# EUROPEAN PATENT SPECIFICATION

(11) **EP 3 496 174 B1**
(45) Date of publication and mention of the grant of the patent: **12.06.2024**
(21) Application number: 18210845.6
(22) Date of filing: 06.11.2015
(51) Int. Cl.: H10K 71/15, H10K 85/10, H10K 85/20, H10K 85/40, C09D 11/033, C09D 11/52, C09D 11/106, H10K 10/46, H10K 30/30

(54) **INK COMPOSITION AND PHOTOELECTRIC CONVERSION ELEMENT PRODUCED USING SAME**
TINTENZUSAMMENSETZUNG UND DAMIT HERGESTELLTES PHOTOELEKTRISCHES UMWANDLUNGSELEMENT
COMPOSITION D'ENCRE ET ÉLÉMENT DE CONVERSION PHOTOÉLECTRIQUE PRODUIT À L'AIDE DE CELLE-CI

(30) Priority: 13.11.2014 JP 2014230429
(43) Date of publication of application: 12.06.2019
(62) Divisional of application: 15858678.4
(73) Proprietor: SUMITOMO CHEMICAL COMPANY, LIMITED, Tokyo 103-6020 (JP)
(72) Inventor: SHEN, Xiaoxiao, Ibaraki, 300-3294 (JP); NAKATANI, Tomoya, Ibaraki, 300-3294 (JP)
(74) Representative: J A Kemp LLP

(56) References cited:
- EP-A1- 2 517 274
- EP-B1- 2 748 877
- JP-A- 2007 173 636
- JP-A- 2014 189 666
- US-A1- 2014 147 996

## Description

### Technical Field

The present invention relates to an ink composition and a photoelectric conversion device produced using the same.

### Background Art

An organic film solar battery can be possibly produced inexpensively only by an application process and is receiving attention recently. It is known that when an organic film solar battery is produced by an application method, an active layer contained in the battery is in general formed by forming a film using an ink composition containing an active layer constituent material and a solvent (Patent document 1 and Patent document 2) .
[Patent Document 1] Japanese Patent Application National Publication No. 2013-533606
[Patent Document 2] Japanese Patent Application National Publication No. 2011-500500 Documents EP2748877 (B), US2014147996 (A1), and JP2014189666 (A) disclose semiconducting polymer ink compositions comprising mixtures low and high boiling point solvents.

### Summary of the Invention

In an organic film solar battery, to enhance its short circuit current density is important for increasing its photoelectric conversion efficiency. When a film formed by using a conventional ink composition containing a P-type semiconductor material, an N-type semiconductor material and a solvent is used as an active layer, however, high short circuit current density cannot be necessarily obtained.

The present invention has an object of providing an ink composition containing several solvents with which high short circuit current density can be obtained. Further, the present invention has an object of providing a photoelectric conversion device produced by using the above-described ink composition.

### Modes for Carrying Out the Invention

### <Explanation of common terms>

"Polymer compound" denotes a polymer having molecular weight distribution and having a polystyrene-equivalent number-average molecular weight of 1×10³ to 1×10⁸. The total amount of constitutional units contained in the polymer compound is 100% by mol.

"Low molecular weight compound" denotes a compound having no molecular weight distribution and having a molecular weight of 1×10⁴ or less.

"Constitutional unit" denotes one or more units present in a polymer compound.

"Hydrogen atom" may be a light hydrogen atom or a heavy hydrogen atom.

"Halogen atom" includes a fluorine atom, a chlorine atom, a bromine atom and an iodine atom.

"Alkyl group" may be any of linear, branched and cyclic. The linear alkyl group has a number of carbon atoms of usually 1 to 50, preferably 3 to 30, more preferably 4 to 20, not including the number of carbon atoms of the substituent. The branched and cyclic alkyl groups have a number of carbon atoms of usually 3 to 50, preferably 3 to 30, more preferably 4 to 20, not including the number of carbon atoms of the substituent.

The alkyl group optionally has a substituent, and examples of the alkyl group include unsubstituted alkyl groups such as a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, an adamantyl group, a n-decyl group, a 3,7-dimethyloctyl group, a 2-ethyloctyl group, a 2-n-hexyldecyl group, a n-dodecyl group, a tetradecyl group, a hexadecyl group, an octadecyl group, an eicosyl group and the like; and substituted alkyl groups such as a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl)propyl group, a 6-ethyloxyhexyl group and the like.

"Aryl group" denotes an atomic group remaining after removing from an aromatic hydrocarbon one hydrogen atom bonding directly to a carbon atom constituting the ring. The aryl group has a number of carbon atoms of usually 6 to 60, preferably 6 to 20, more preferably 6 to 10, not including the number of carbon atoms of the substituent.

The aryl group optionally has a substituent, and examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom of these groups with an alkyl group, an alkoxy group, an aryl group, a fluorine atom or the like.

"Alkoxy group" may be any of linear, branched and cyclic. The linear alkoxy group has a number of carbon atoms of usually 1 to 40, preferably 4 to 10, not including the number of carbon atoms of the substituent. The branched and cyclic alkoxy groups have a number of carbon atoms of usually 3 to 40, preferably 4 to 10, not including the number of carbon atoms of the substituent.

The alkoxy group optionally has a substituent, and examples of the alkoxy group include a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group and a lauryloxy group.

"Aryloxy group" has a number of carbon atoms of usually 6 to 60, preferably 7 to 48, not including the number of carbon atoms of the substituent.

The aryloxy group optionally has a substituent, and examples of the alkyl group include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom of these groups with an alkyl group, an alkoxy group, a fluorine atom or the like.

"Alkylthio group" may be any of linear, branched and cyclic. The linear alkoxy group has a number of carbon atoms of usually 1 to 40, preferably 4 to 10, not including the number of carbon atoms of the substituent. The branched and cyclic alkoxy groups have a number of carbon atoms of usually 3 to 40, preferably 4 to 10, not including the number of carbon atoms of the substituent.

The alkylthio group optionally has a substituent, and examples of the alkylthio group include a methylthio group, an ethylthio group, a propylthio group, an isopropylthio group, a butylthio group, an isobutylthio group, a tert-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group and a trifluoromethylthio group.

"Arylthio group" has a number of carbon atoms of usually 6 to 60, preferably 7 to 48, not including the number of carbon atoms of the substituent.

The arylthio group optionally has a substituent, and examples of the arylthio group include a phenylthio group, a C1 to C12 alkyloxyphenylthio group (C1 to C12 means that the number of carbon atoms is 1 to 12, the same shally apply hereinafter.), a C1 to C12 alkylphenylthio group, a 1-naphthylthio group, a 2-naphthylthio group and a pentafluorophenylthio group.

"p-Valent heterocyclic group" (p represents an integer of 1 or more) denotes an atomic group remaining after removing from a heterocyclic compound p hydrogen atoms among hydrogen atoms bonding directly to carbon atoms or hetero atoms constituting the ring. Of the p-valent heterocyclic groups, preferable are "p-valent aromatic heterocyclic groups" as an atomic group remaining after removing from an aromatic heterocyclic compound p hydrogen atoms among hydrogen atoms bonding directly to carbon atoms or hetero atoms constituting the ring.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole and the like; and a compound in which an aromatic ring is condensed to the heterocyclic ring even if the heterocyclic ring itself shows no aromaticity such as phenoxazine, phenothiazine, dibenzoborole, dibenzosilole, benzopyran and the like.

The mono-valent heterocyclic group has a number of carbon atoms of usually 2 to 60, preferably 4 to 20, not including the number of carbon atoms of the substituent.

The mono-valent heterocyclic group optionally has a substituent, and examples of the mono-valent heterocyclic group include, for example, a thienyl group, a pyrrolyl group, a furyl group, a pyridyl group, a piperidyl group, a quinolyl group, an isoquinolyl group, a pyrimidinyl group and a triazinyl group, and groups obtained by substituting a hydrogen atom of these groups with an alkyl group, an alkoxy group or the like.

"Substituted amino group" is an amino group having two substituents. Examples of the substituent of the amino group include preferably an alkyl group, an aryl group or a mono-valent heterocyclic group.

The substituted amino group has a number of carbon atoms of usually 2 to 30.

Examples of the substituted amino group include, for example, dialkylamino groups such as a dimethylamino group, a diethylamino group and the like; and diarylamino groups such as a diphenylamino group, a bis(4-methylphenyl)amino group, a bis(4-tert-butylphenyl)amino group, a bis(3,5-di-tert-butylphenyl)amino group and the like.

"Acyl group" has a number of carbon atoms of usually about 2 to 20, preferably 2 to 18, and as examples thereof, an acetyl group, a propionyl group, a butyryl group, an isobutyryl group, a pivaloyl group, a benzoyl group, a trifluoroacetyl group, a pentafluorobenzoyl group and the like are exemplified.

"Imine residue" includes residues obtained by removing one hydrogen atom from imine compounds (denoting an organic compound having -N=C- in the molecule. Examples thereof include aldimines, ketimines, and compounds obtained by substituting a hydrogen atom on N of these compounds with an alkyl group or the like.), and has a number of carbon atoms of usually about 2 to 20, preferably 2 to 18. Examples of the imine residue include groups represented by the following structural formulae, and the like.

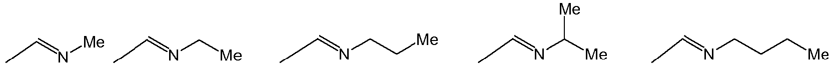

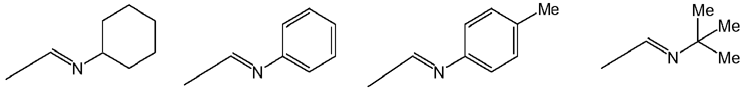

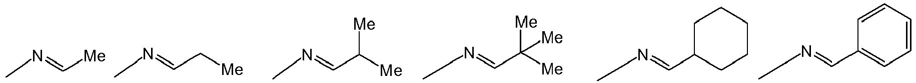

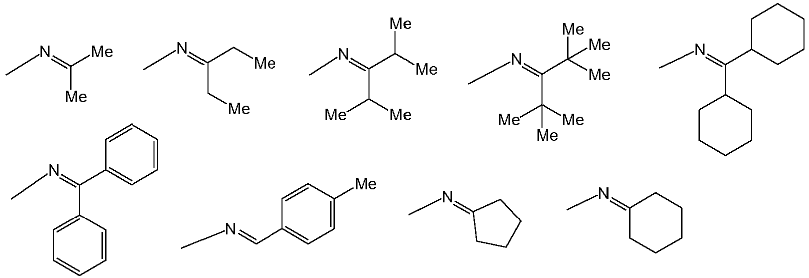

"Substituted amide group" has a number of carbon atoms of usually about 2 to 20, preferably 2 to 18, and examples of the substituted amide group include a formamide group, an acetamide group, a propioamide group, a butyramide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, a dipentafluorobenzamide group and the like.

"Acid imide group" includes residues obtained by removing from an acid imide a hydrogen atom bonding to its nitrogen atom, and has a number of carbon atoms of about 4 to 20, and examples of the acid imide group include groups shown below, and the like.

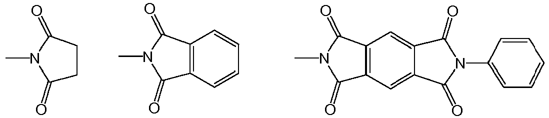

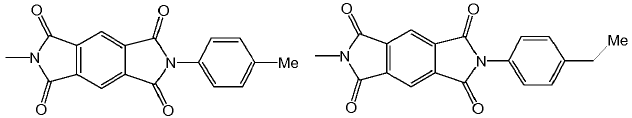

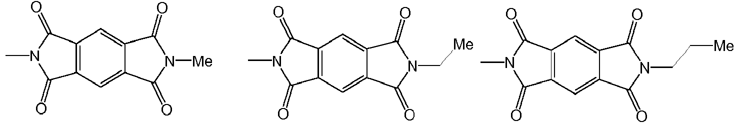

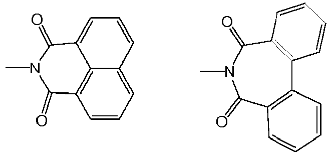

"Substituted carboxyl group" denotes a carboxyl group substituted with an alkyl group, an aryl group, an arylalkyl group or a mono-valent heterocyclic group, and has a number of carbon atoms of usually about 2 to 60, preferably 2 to 48.

Examples of "substituted carboxyl group" include a methoxycarbonyl group, an ethoxycarbonyl group, a propoxycarbonyl group, an isopropoxycarbonyl group, a butoxycarbonyl group, an isobutoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, a pyridyloxycarbonyl group and the like.

"Alkenyl group" may be any of linear, branched or cyclic. The linear alkenyl group has a number of carbon atoms of usually 2 to 30, preferably 3 to 20, not including the number of carbon atoms of the substituent. The branched and cyclic alkenyl groups have a number of carbon atoms of usually 3 to 30, preferably 4 to 20, not including the number of carbon atoms of the substituent.

The alkenyl group optionally has a substituent, and examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"Alkynyl group" may be any of linear, branched or cyclic. The alkynyl group has a number of carbon atoms of usually 2 to 20, preferably 3 to 20, not including the number of carbon atoms of the substituent. The branched and cyclic alkynyl groups have a number of carbon atoms of usually 4 to 30, preferably 4 to 20, not including the number of carbon atoms of the substituent.

The alkynyl group optionally has a substituent, and examples of the alkynyl group include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

### <Ink composition>

The ink composition of the present invention is an ink composition according to the claims comprising a P-type semiconductor material, an N-type semiconductor material and two solvents the total amount of which is 70% by weight or more with respect to 100% by weight of all solvents, wherein, the one having lower boiling point among the two solvents is called a first solvent and the other having higher boiling point is called a second solvent, then, the hydrogen bond Hansen solubility parameter H1 (MPa^{0.5}) of the first solvent and the hydrogen bond Hansen solubility parameter H2 (MPa^{0.5}) of the second solvent are in the relation of 0.5 ≤ (H2-H1) ≤ 5.0.

That is, the ink composition of the present invention is an ink composition according to the claims comprising a P-type semiconductor material, an N-type semiconductor material and two or more solvents including a first solvent and a second solvent, wherein
the total amount of the first solvent and the second solvent is 70% by weight or more with respect to 100% by weight of all the solvents contained in the ink composition;
the boiling point of the first solvent is lower than the boiling point of the second solvent; and
the hydrogen bond Hansen solubility parameter H1 (MPa^{0.5}) of the first solvent and the hydrogen bond Hansen solubility parameter H2 (MPa^{0.5}) of the second solvent are in the relation of 0.5 ≤ (H2-H1) ≤ 5.0.

The upper limit of the total amount of the first solvent and the second solvent is 100% by weight with respect to 100% by weight of all the solvents.

The boiling point of the first solvent in the ink composition of the present invention is 120°C or more and 400°C or less.

In the ink composition of the present invention, further one or more other solvents may be contained in addition to the first solvent and the second solvent. The amount of the first solvent is the largest among all the solvents contained in the ink composition. That is, the amount of the first solvent is preferably 35% by weight or more, more preferably 50% by weight or more with respect to 100% by weight of all the solvents. When the amount of the first solvent is the largest among all the solvents, it is preferable that the amount of the second solvent is the second largest among all the solvents.

### [Hansen solubility parameter]

As the hydrogen bond Hansen solubility parameter and the polarity Hansen solubility parameter used in the present invention, values defined in "Hansen solubility parameters in practice 4^{th} edition" are used.

In the ink composition of the present invention, the difference between the hydrogen bond Hansen solubility parameter H1 (MPa^{0.5}) of the first solvent and the hydrogen bond Hansen solubility parameter H2 (MPa^{0.5}) of the second solvent is in the range of 0.5 ≤ (H2-H1) ≤ 5.0, and from the standpoint of obtaining high short circuit current density, the range is preferably 1.0 ≤ (H2-H1) ≤ 5.0, more preferably 1.7 ≤ (H2-H1) ≤ 5.0, further preferably 2.1 ≤ (H2-H1) ≤ 5.0, further more preferably 2.4 ≤ (H2-H1) ≤ 5.0, still more preferably 2.4 ≤ (H2-H1) ≤ 4.6.

The difference between the polarity Hansen solubility parameter P1 (MPa^{0.5}) of the first solvent and the polarity Hansen solubility parameter P2 (MPa^{0.5}) of the second solvent is preferably in the range of 1.0 ≤ (P2-P1) ≤ 9. 0, more preferably 2.0 ≤ (P2-P1) ≤ 9.0, further preferably 3.5 ≤ (P2-P1) ≤ 9.0, further more preferably 3.5 ≤ (P2-P1) ≤ 7.5, from the standpoint of obtaining further higher short circuit current density.

### [Boiling point]

The boiling point of the first solvent contained in the ink composition of the present invention is lower than the boiling point of the second solvent. The difference between the boiling point of the first solvent and the boiling point of the second solvent is preferably 5°C or more and 200°C or less, more preferably 10°C or more and 180°C or less, from the standpoint of obtaining high current density.

The boiling point of the first solvent is preferably 140°C or more, more preferably 150°C or more. The boiling point of the first solvent is preferably 350°C or less, more preferably 300°C or less.

### [First solvent]

As the first solvent contained in the ink composition of the present invention, a solvent having solubility for a P-type semiconductor material in the ink composition is preferable, and a solvent having solubility for both a P-type semiconductor material and an N-type semiconductor material is more preferable. Examples of the first solvent include aromatic hydrocarbon solvents such as toluene, o-xylene, m-xylene, p-xylene, mesitylene, pseudocumene, 1,2,3,5-tetramethylbenzene, ethylbenzene, n-hexylbenzene, cyclohexylbenzene, 1-methylnaphthalene and the like;
The first solvent is an aromatic hydrocarbon solvent, from the standpoint of solubility of a P-type semiconductor material.

The first solvent is preferably a compound having an alkyl group as a substituent, more preferably a compound having a methyl group as a substituent, among aromatic hydrocarbon solvents, from the standpoint of solubility of a P-type semiconductor material.

As the first solvent, benzenes substituted with an alkyl group are preferable, toluene, o-xylene, m-xylene, p-xylene, mesitylene, pseudocumene, 1,2,3,5-tetramethylbenzene, ethylbenzene, n-hexylbenzene or cyclohexylbenzene is more preferable, toluene, o-xylene, m-xylene, p-xylene, mesitylene, pseudocumene or 1,2,3,5-tetramethylbenzene is further preferable, mesitylene, pseudocumene or 1,2,3,5-tetramethylbenzene is further more preferable, among aromatic hydrocarbon solvents, from the standpoint of obtaining a good film.

### [Second solvent]

The second solvent contained in the ink composition of the present invention is preferably a solvent having solubility for an N-type semiconductor material in the ink composition. The second solvent includes, for example, ether solvents such as tetrahydrofuran, dioxane, anisole, 4-methylanisole, diphenyl ether, dibenzyl ether and the like; ketone solvents such as acetone, methyl ethyl ketone, cyclohexanone, acetophenone, propiophenone and the like; ester solvents such as ethyl acetate, butyl acetate, phenyl acetate, ethyl cellosolve acetate, methyl benzoate, butyl benzoate, benzyl benzoate and the like.

It is preferable that the second solvent has an aromatic hydrocarbon ring from the standpoint of obtaining a good film, and preferable as the ether solvent are anisole, 4-methylanisole, diphenyl ether, dibenzyl ether and the like; as the ketone solvent are acetophenone, propiophenone and the like; as the ester solvent are phenyl acetate, methyl benzoate, butyl benzoate, benzyl benzoate and the like; as the ketone solvent are acetophenone and propiophenone; as the ester solvent are methyl benzoate, butyl benzoate and benzyl benzoate.

The second solvent is an ether solvent, an a ketone solvent or an ester solvent, further more preferably a ketone solvent or an ester solvent, from the standpoint of solubility of an N-type semiconductor material.

### [Solvent other than first solvent and second solvent]

The ink composition of the present invention may contain other solvents in addition to the first solvent and the second solvent. When other solvents are contained, preferable as the other solvent is a solvent having boiling point higher than that of the first solvent, and it is preferable that the difference of the Hansen solubility parameter between the first solvent and the other solvent is in the preferable range of the difference of the Hansen solubility parameter between the first solvent and the second solvent. That is, the hydrogen bond Hansen solubility parameter H1 (MPa^{0.5}) of the first solvent and the hydrogen bond Hansen solubility parameter H3 (MPa^{0.5}) of the other solvent are preferably in the relation of 1.0 ≤ (H3-H1) ≤ 5.0, more preferably 1.7 ≤ (H3-H1) ≤ 5.0, further preferably 2.1 ≤ (H3-H1) ≤ 5.0, further more preferably 2.4 ≤ (H3-H1) ≤ 5.0, still more preferably 2.4 ≤ (H3-H1) ≤ 4.6. The other solvent is selected, for example, from examples of the second solvent.

As the other solvent, a solvent having boiling point higher than that of the second solvent is preferable.

### [Combination of first solvent with second solvent]

The total amount of the first solvent and the second solvent contained in the ink composition of the present invention is 70% by weight or more with respect to 100% by weight of all solvents, and from the standpoint of solubility of a P-type semiconductor material and/or an N-type semiconductor material, the total amount is preferably 80% by weight or more, more preferably 90% by weight or more. The ratio of the first solvent to the second solvent in the ink composition of the present invention is preferably in the range of 70:30 to 99:1, further more preferably 90:10 to 99:1, in terms of the weight ratio (amount of first solvent:amount of second solvent), from the standpoint of solubility of a P-type semiconductor material and an N-type semiconductor material.

Examples of a combination of the first solvent with the second solvent (first solvent/second solvent) include toluene/diphenyl ether, toluene/dibenzyl ether, toluene/acetophenone, toluene/propiophenone, toluene/methyl benzoate, toluene/butyl benzoate, toluene/benzyl benzoate, o-xylene/diphenyl ether, o-xylene/dibenzyl ether, o-xylene/acetophenone, o-xylene/propiophenone, o-xylene/methyl benzoate, o-xylene/butyl benzoate, o-xylene/benzyl benzoate, m-xylene/diphenyl ether, m-xylene/dibenzyl ether, m-xylene/acetophenone, m-xylene/propiophenone, m-xylene/methyl benzoate, m-xylene/butyl benzoate, m-xylene/benzyl benzoate, p-xylene/diphenyl ether, p-xylene/dibenzyl ether, p-xylene/acetophenone, p-xylene/propiophenone, p-xylene/methyl benzoate, p-xylene/butyl benzoate, p-xylene/benzyl benzoate, mesitylene/diphenyl ether, mesitylene/dibenzyl ether, mesitylene/acetophenone, mesitylene/propiophenone, mesitylene/methyl benzoate, mesitylene/butyl benzoate, mesitylene/benzyl benzoate, pseudocumene/diphenyl ether, pseudocumene/dibenzyl ether, pseudocumene/acetophenone, pseudocumene/propiophenone, pseudocumene/methyl benzoate, pseudocumene/butyl benzoate and pseudocumene/benzyl benzoate.

The combination of the first solvent with the second solvent is preferably o-xylene/diphenyl ether, o-xylene/dibenzyl ether, o-xylene/acetophenone, o-xylene/propiophenone, o-xylene/methyl benzoate, o-xylene/butyl benzoate, o-xylene/benzyl benzoate, m-xylene/diphenyl ether, m-xylene/dibenzyl ether, m-xylene/acetophenone, m-xylene/propiophenone, m-xylene/methyl benzoate, m-xylene/butyl benzoate, m-xylene/benzyl benzoate, p-xylene/diphenyl ether, p-xylene/dibenzyl ether, p-xylene/acetophenone, p-xylene/propiophenone, p-xylene/methyl benzoate, p-xylene/butyl benzoate, p-xylene/benzyl benzoate, mesitylene/diphenyl ether, mesitylene/dibenzyl ether, mesitylene/acetophenone, mesitylene/propiophenone, mesitylene/methyl benzoate, mesitylene/butyl benzoate, mesitylene/benzyl benzoate, pseudocumene/diphenyl ether, pseudocumene/dibenzyl ether, pseudocumene/acetophenone, pseudocumene/propiophenone, pseudocumene/methyl benzoate, pseudocumene/butyl benzoate or pseudocumene/benzyl benzoate, more preferably mesitylene/diphenyl ether, mesitylene/dibenzyl ether, mesitylene/acetophenone, mesitylene/propiophenone, mesitylene/methyl benzoate, mesitylene/butyl benzoate, mesitylene/benzyl benzoate, pseudocumene/diphenyl ether, pseudocumene/dibenzyl ether, pseudocumene/acetophenone, pseudocumene/propiophenone, pseudocumene/methyl benzoate, pseudocumene/butyl benzoate or pseudocumene/benzyl benzoate, from the standpoint of stability of the ink composition.

### [P-type semiconductor material]

The P-type semiconductor material used in the present invention is a polymer compound according to the claims.

It is preferable that the P-type semiconductor material is a polymer compound from the standpoint of stability of the ink composition.

It is preferable that the above-described polymer compound is a polymer compound containing a repeating unit represented by the following formula (I-1) and/or the following formulae (II-1, II-2, II-3, II-4, II-6) from the standpoint of photoelectric conversion efficiency when producing a photoelectric conversion device using the ink composition of the present invention. 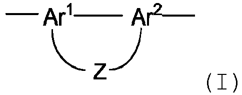 [in the formula (I), Ar¹ and Ar² represent a trivalent aromatic heterocyclic group, and Z represents a divalent group represented by (Z-1) to (Z-7).].

-Ar³- (II)

[in the formula (II), Ar³ represents a divalent aromatic heterocyclic group according to formulas II-1 - II-4 and II-6.].

In the formula (I), Z represents a group represented by any one of the following formula (2-1) to formula (2-7).

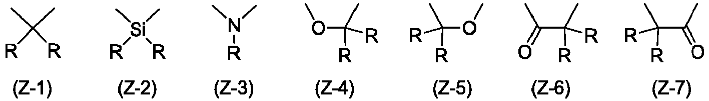

In the formula (2-1) to the formula (Z-7), R represents a hydrogen atom, a halogen atom, an alkyl group, an aryl group, an alkoxy group, an aryloxy group, an alkylthio group, an arylthio group, a mono-valent heterocyclic group, a substituted amino group, an acyl group, an imine residue, a substituted amide group, an acid imide group, a substituted carboxyl group, an alkenyl group, an alkynyl group, a cyano group or a nitro group. When there are two groups R in each of the formula (2-1) to the formula (Z-7), they may be the same or mutually different.

The trivalent aromatic heterocyclic group represented by Ar¹ and Ar² in the formula (I) denotes an atomic group remaining after removing from an optionally substituted heterocyclic compound having aromaticity three hydrogen atoms on the aromatic ring. The trivalent aromatic heterocyclic group has a number of carbon atoms of 4 and is a group according to the claims.

Examples of the substituent which a heterocyclic compound having aromaticity optionally has include a halogen atom, an alkyl group, an aryl group, an alkoxy group, an aryloxy group, an alkylthio group, an arylthio group, a mono-valent heterocyclic group, a substituted amino group, an alkenyl group, an alkynyl group or a cyano group.

The constitutional unit represented by the above-described formula (I) is a constitutional unit represented by the following formula (1-1). 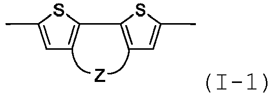 [in the formula (I-1), Z represents the same meaning as described above.]

Examples of the constitutional unit represented by the formula (1-1) include constitutional units represented by the formula (501) to the formula (505). 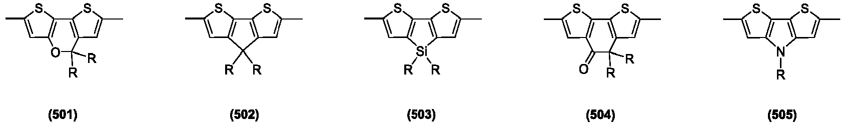 [wherein, R represents the same meaning as described above. When there are two groups R, they may be the same or different.]

Of constitutional units represented by the formula (501) to the formula (505) described above, preferable are constitutional units represented by the formula (501), the formula (502), the formula (503) and the formula (504), more preferable are constitutional units represented by the formula (501) and the formula (504), particularly preferable is a constitutional unit represented by the formula (501), from the standpoint of obtaining highly efficient photoelectric conversion device of the present invention.

The divalent aromatic heterocyclic group represented by Ar³ in the formula (II) denotes an atomic group remaining after removing from an optionally substituted heterocyclic compound having aromaticity two hydrogen atoms on the aromatic ring. The divalent aromatic heterocyclic group is a group according to formulas II-1, II-2, II-3, II-4, and II-6.

Examples of the substituent which a heterocyclic compound having aromaticity optionally has include a halogen atom, an alkyl group, an aryl group, an alkoxy group, an aryloxy group, an alkylthio group, an arylthio group, a mono-valent heterocyclic group, a substituted amino group, an acyl group, an imine residue, a substituted amide group, an acid imide group, a substituted carboxyl group, an alkenyl group, an alkynyl group, a cyano group or a nitro group.

Examples of the divalent aromatic heterocyclic group represented by Ar³ include the following formula 132, 136, 140, 142, 159, 163, 173, 175, 176, the formula 101 to 131, 133 to 135, 137 to 139, 141, 143 to 158, 160 to 162, 164 to 172, 174, 177 to 185 are reference formula not forming part of the present invention. 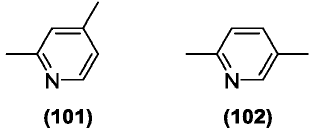 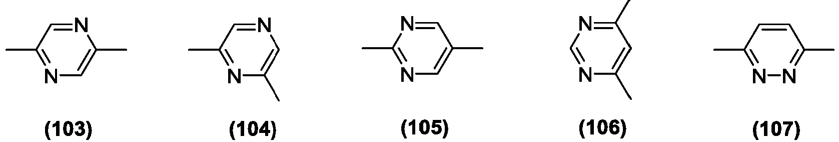 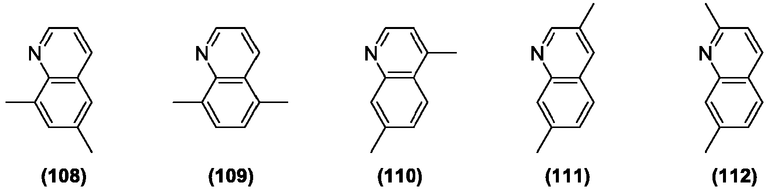 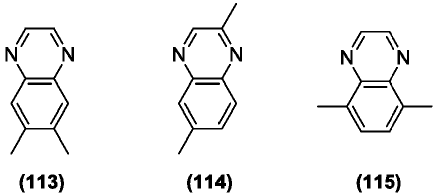 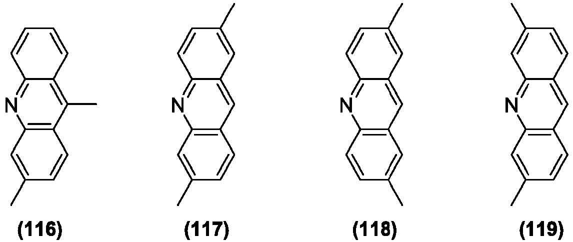 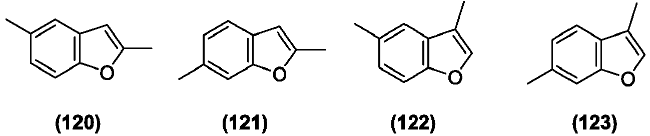 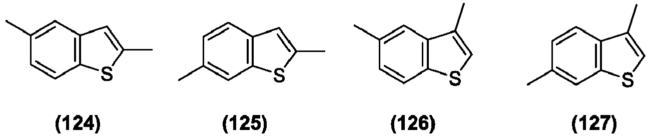 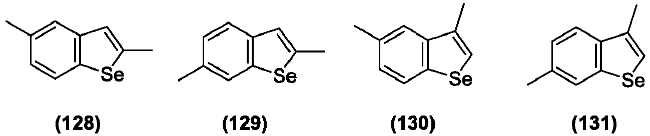 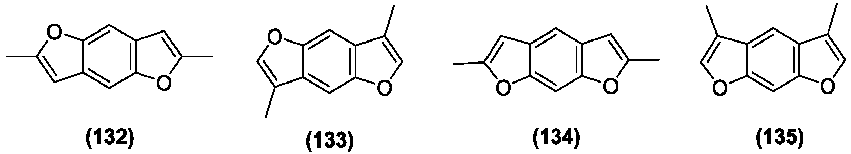 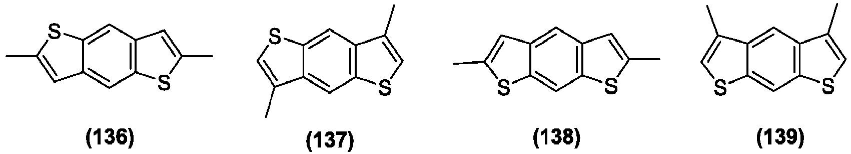 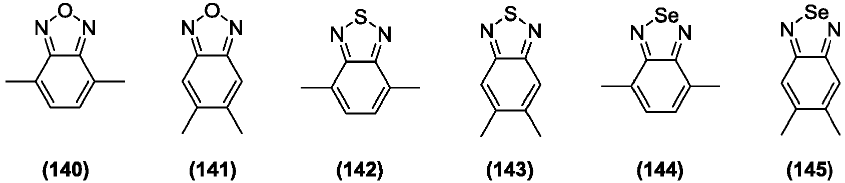 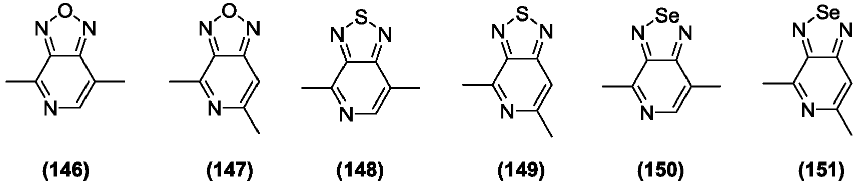 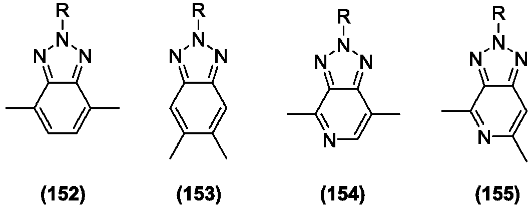 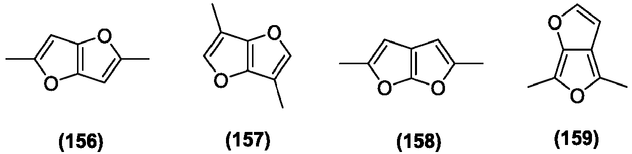 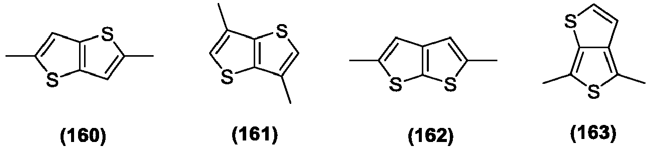 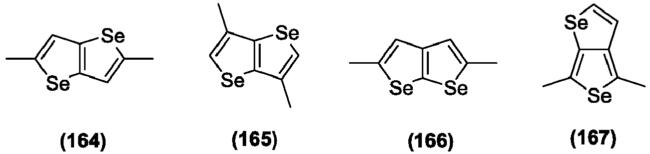 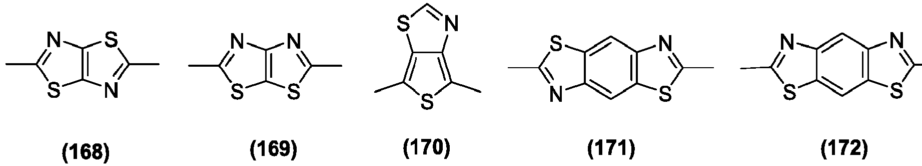 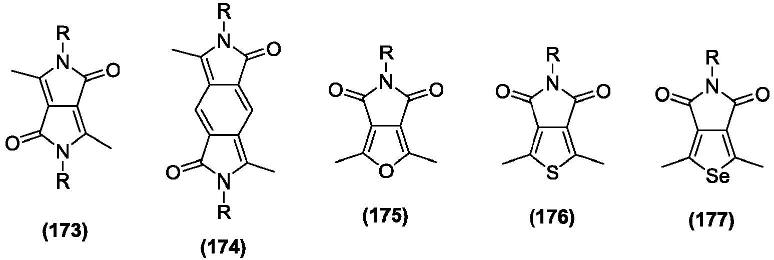 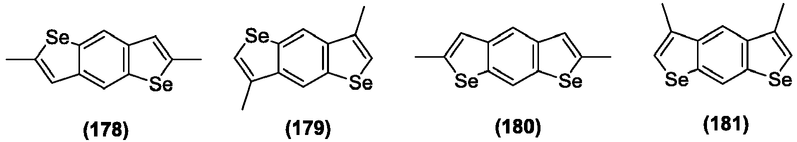 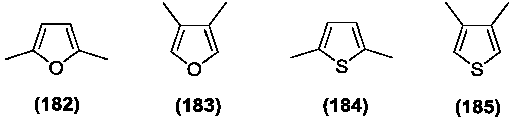 (wherein, R represents the same meaning as described above. When a plurality of R are present, they may be the same or different.).

The P-type semiconductor material is a polymer compound comprising a repeating unit represented by the formula (I-1) and/or the following formula (II-1) to (II-4) or (II-6): 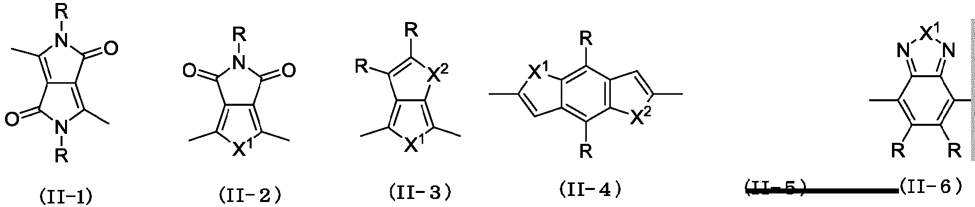 (wherein, X¹ and X² each independently represent an oxygen atom or a sulfur atom, and R represents the same meaning as described above. When a plurality of R are present, they may be the same or different.)

It is preferable that both X¹ and X² represent a sulfur atom in the above-described formulae (II-2) to (II-6) from the standpoint of availability of the raw material compound.

The above-described P-type semiconductor material may have two or more constitutional units of the formula (I), or may have two or more constitutional units of the formula (II).

The above-described polymer compound may contain a repeating unit represented by the following formula (III) from the standpoint of solubility in the ink solvent.

-Ar⁴- (III)

[in the formula (III), Ar⁴ represents an arylene group.]

The arylene group is an atomic group obtained by removing from an aromatic hydrocarbon two hydrogen atoms, and includes those having a condensed ring and also those having two or more independent benzene rings or condensed rings connected directly or via a group such as vinylene and the like. The arylene group optionally has a substituent. This substituent includes the same substituents exemplified above.

The number of carbon atoms of a portion excluding the substituent of the arylene group is usually about 6 to 60, preferably 6 to 20. The total number of carbon atoms of the arylene group including the substituent is usually about 6 to 100.

Examples of the arylene group include phenylene groups (for example, the following formulae 1 to 3), naphthalene-diyl groups (the following formulae 4 to 13), anthracene-diyl groups (the following formulae 14 to 19), biphenyl-diyl groups (the following formulae 20 to 25), terphenyl-diyl groups (the following formulae 26 to 28), condensed ring compound groups (the following formulae 29 to 35), fluorene-diyl groups (the following formulae 36 to 38), benzofluorene-diyl groups (the following formulae 39 to 46), and the like.

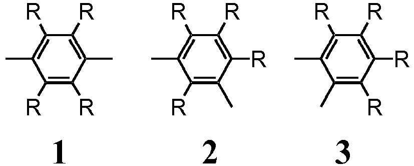

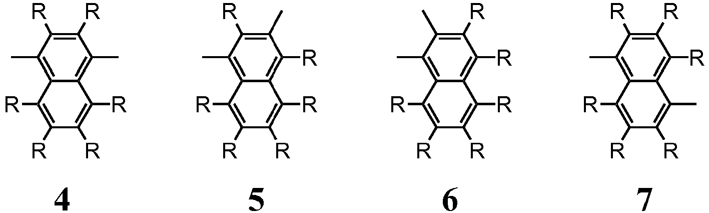

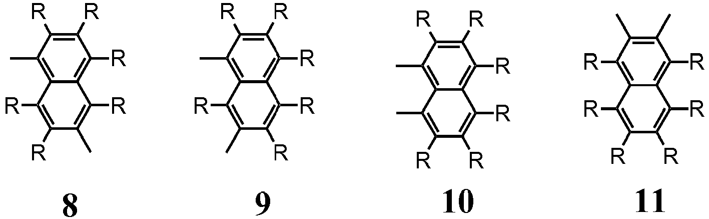

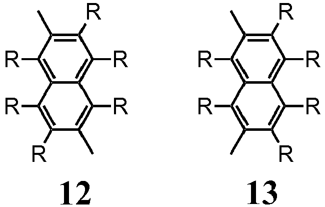

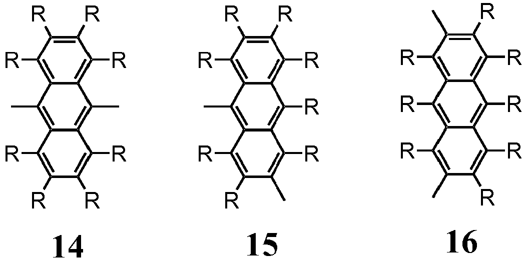

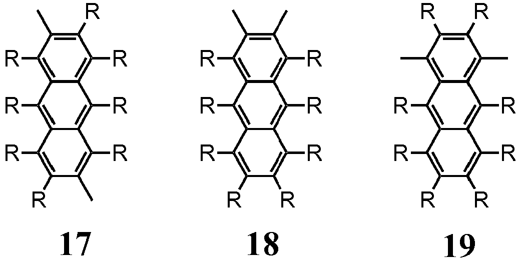

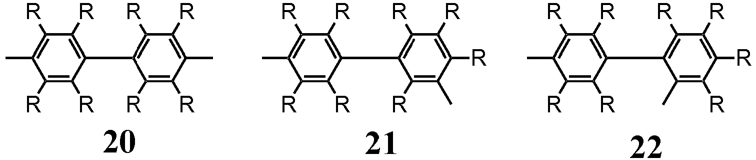

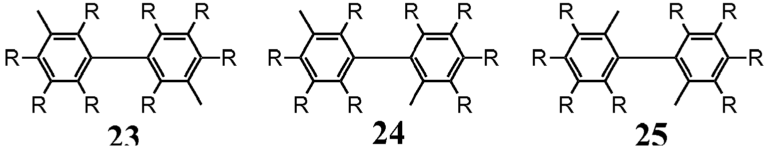

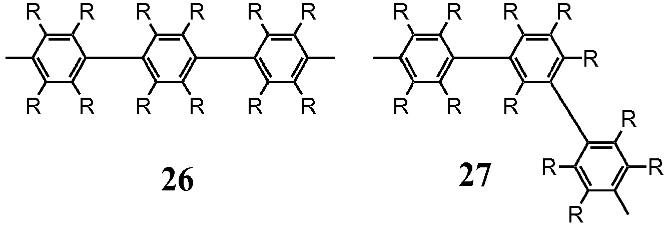

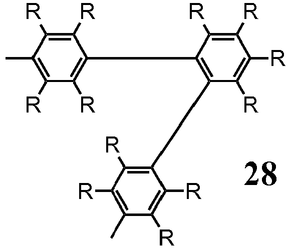

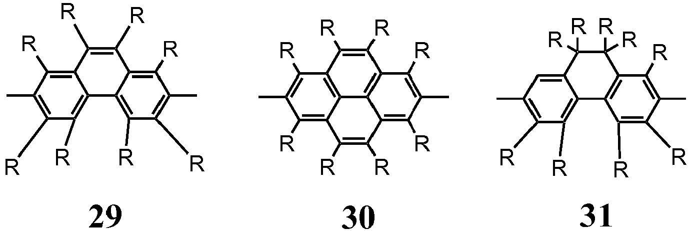

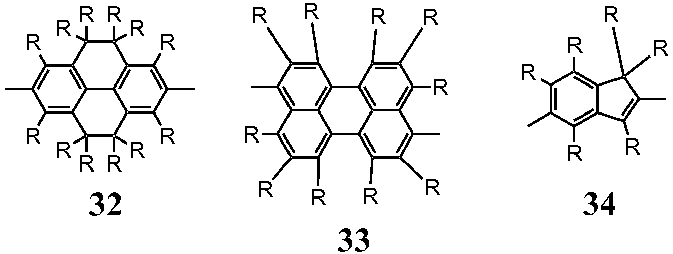

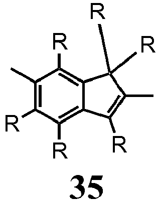

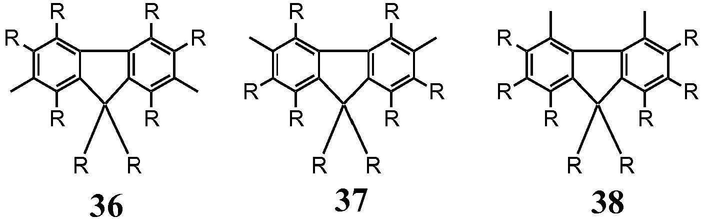

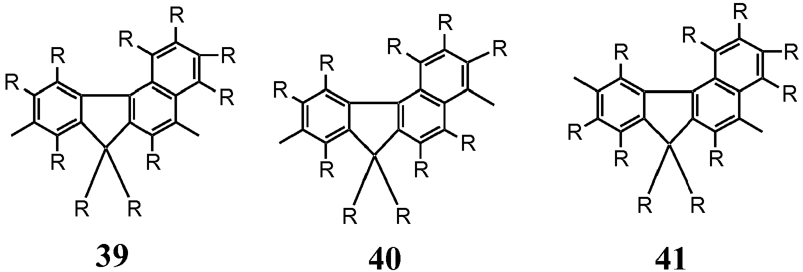

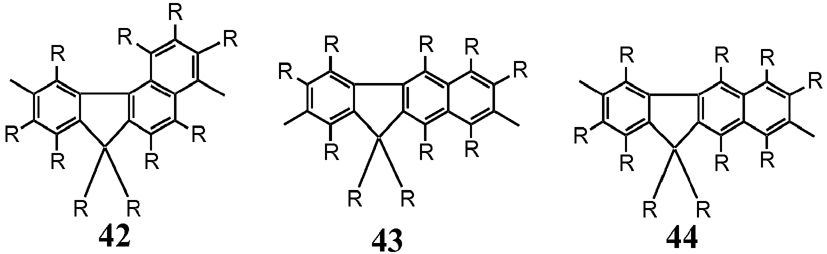

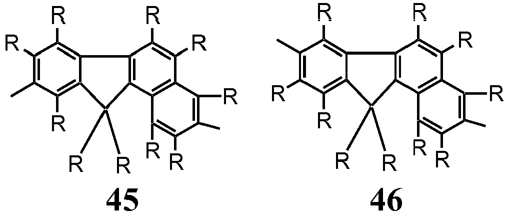

When the polymer compound contained in the ink composition of the present invention contains a constitutional unit of the formula (I-1) (I) and/or a constitutional unit of the formula (II-1) to (II-4) or (II-6) the total amount of the constitutional unit of the formula (I-1) and the constitutional unit of the formula (II-1) to (II-4) or (II-6) is usually 20 to 100 mol% with respect to 100 mol% of the total amount of all constitutional units contained in the polymer compound, and from the standpoint of charge transportability as a p-type semiconductor, the total amount is preferably 40 to 100 mol%, more preferably 50 to 100 mol%.

When the polymer compound contained in the ink composition of the present invention contains a constitutional unit of the formula (I-1) and a constitutional unit of the formula (II-1) to (II-4) or (II-6), the amount of the constitutional unit of the formula (I-1) is usually 20 to 80 mol% with respect to 100 mol% of the total amount of the constitutional unit of the formula (I-1) and the constitutional unit of the formula (II-1) to (II-4) or (II-6), and from the standpoint of solubility of the polymer compound in a solvent, the amount is preferably 30 to 80 mol%, more preferably 40 to 80 mol%.

The polystyrene-equivalent weight-average molecular weight of the polymer compound contained in the ink composition of the present invention is usually 1×10³ to 1×10⁸, and from the standpoint of solubility in a solvent, it is preferably 1×10³ to 1×10⁶.

One P-type semiconductor material may be contained or two or more P-type semiconductor materials may be contained in the ink composition of the present invention.

### [N-type semiconductor material]

The N-type semiconductor material used in the present invention may be a low molecular weight compound or a polymer compound. Examples of the low molecular weight N-type semiconductor material (electron accepting compound) include oxadiazole derivatives, anthraquinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, fullerenes such as C₆₀ and the like and its derivatives, phenanthrene derivatives such as bathocuproine and the like, etc.

The polymer N-type semiconductor material (electron accepting compound) includes polyvinylcarbazole and its derivatives, polysilane and its derivatives, polysiloxane derivatives having an aromatic amine in the side chain or main chain, polyaniline and its derivatives, polythiophene and its derivatives, polypyrrole and its derivatives, polyphenylenevinylene and its derivatives, polythienylenevinylene and its derivatives, polyfluorene and its derivatives, and the like. Among others, fullerenes and derivatives thereof are preferable.

The fullerenes and fullerene derivatives include C₆₀, C₇₀, C₇₆, C₇₈, C₈₄ and derivatives thereof. The fullerene derivative denotes a compound obtained by at least partially modifying a fullerene.

Examples of the fullerene derivative include a compound represented by the formula (N-1), a compound represented by the formula (N-2), a compound represented by the formula (N-3) and a compound represented by the formula (N-4). 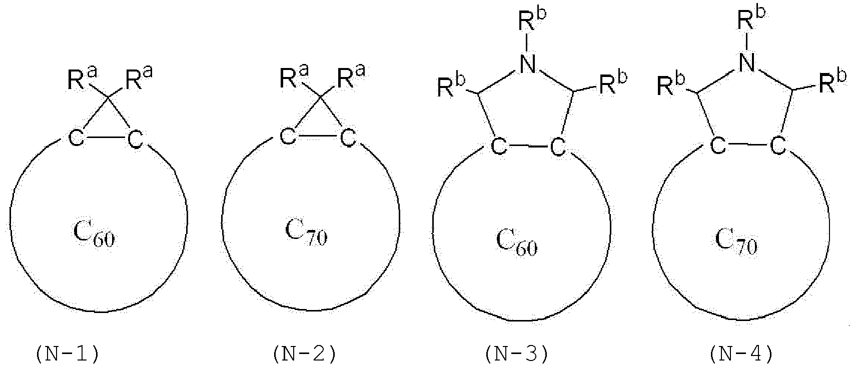 (in the formulae (N-1) to (N-4), R^{a} is an optionally substituted alkyl group, an aryl group, a mono-valent heterocyclic group or a group having an ester structure. A plurality of R^{a} may be the same or different mutually. R^{b} represents an alkyl group or an aryl group. A plurality of R^{b} may be the same or different mutually.)

The group having an ester structure represented by R^{a} includes, for example, groups represented by the formula (19) . 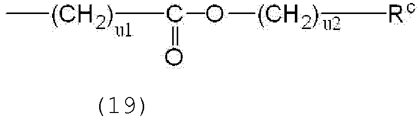 (wherein, u1 represents an integer of 1 to 6, u2 represents an integer of 0 to 6, and R^{c} represents an alkyl group, an aryl group or a mono-valent heterocyclic group.).

Examples of the C₆₀ fullerene derivative include the following compounds.

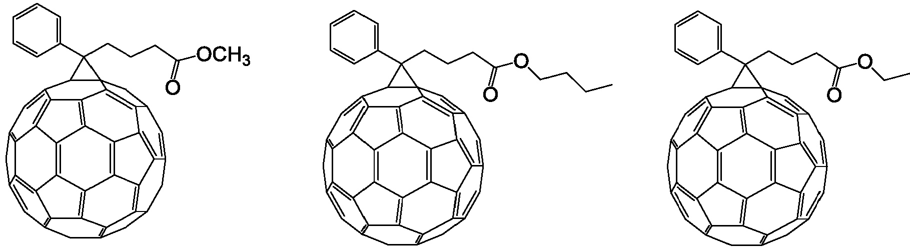

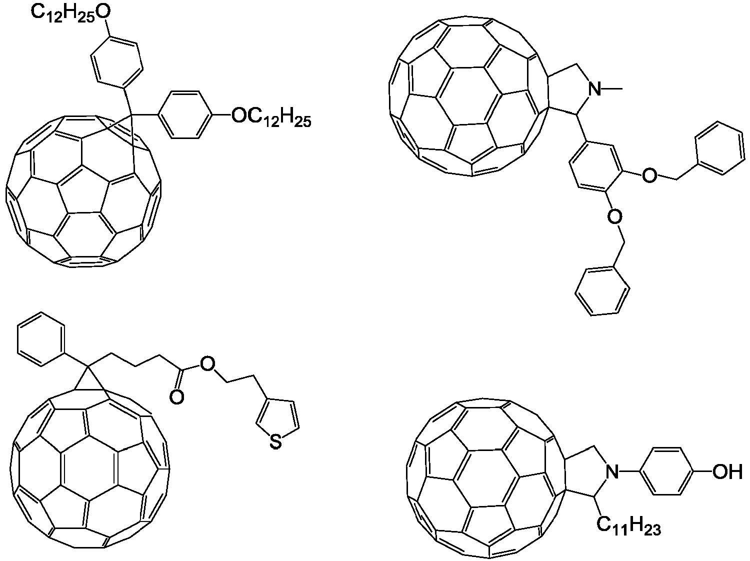

Examples of the C₇₀ fullerene derivative include the following compounds.

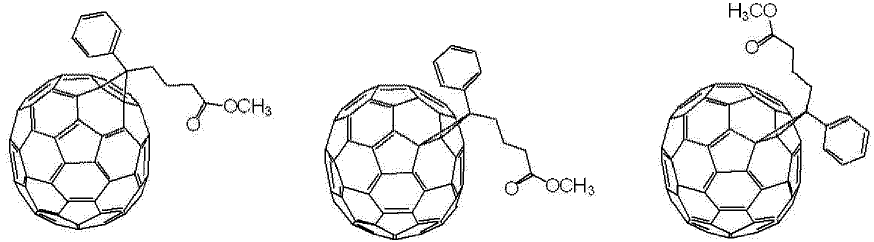

Examples of the fullerene derivative include [6,6]phenyl-C61butyric acid methyl ester (C60PCBM, [6,6]-Phenyl C61 butyric acid methyl ester), [6,6]phenyl-C71butyric acid methyl ester (C70PCBM, [6,6]-Phenyl C71 butyric acid methyl ester), [6,6]phenyl-C85butyric acid methyl ester (C84PCBM, [6,6]-Phenyl C85 butyric acid methyl ester) and [6, 6] thienyl-C61butyric acid methyl ester ([6,6]-Thienyl C61 butyric acid methyl ester).

One N-type semiconductor material may be contained or two or more N-type semiconductor materials may be contained in the ink composition of the present invention.

### [Composition of P-type semiconductor material and N-type semiconductor material]

The weight ratio of a P-type semiconductor material to an N-type semiconductor material in the ink composition of the present invention is preferably 9:1 to 1:9, more preferably 2:1 to 1: 9, further preferably 1:1 to 1: 9, particularly preferably 1:1 to 1:5, from the standpoint of photoelectric conversion efficiency.

### [Concentration of solid component in ink composition]

The concentration by weight of solid components including a P-type semiconductor material and an N-type semiconductor material in the ink composition is preferably 0.01 wt% to 20 wt%, more preferably 0.01 wt% to 10 wt%, further preferably 0.01 wt% to 5 w%, particularly preferably 0.1 w% to 5 w%, from the standpoint of photoelectric conversion efficiency. Solid components may be dissolved or dispersed, and it is preferable that they are dissolved, and it is more preferable that they are dissolved completely.

### <Film>

A film can be formed using the ink composition of the present invention. The preferable method of forming the film of the present invention is a film formation method comprising a step of forming a coated film by an application method using the ink composition of the present invention and a drying step of removing a solvent from the above-described coated film.

For formation of a coated film, application methods such as a slit coat method, a knife coat method, a spin coat method, a casting method, a micro gravure coat method, a gravure coat method, a bar coat method, a roll coat method, a wire bar coat method, a dip coat method, a spray coat method, a screen printing method, a gravure printing method, a flexo printing method, an offset printing method, an inkjet coat method, a dispenser printing method, a nozzle coat method, a capillary coat method and the like can be used, and a slit coat method, a capillary coat method, a gravure coat method, a micro gravure coat method, a bar coat method, a knife coat method, a nozzle coat method, an inkjet coat method and a spin coat method are preferable.

The surface tension of a mixed solvent in the ink composition at 25°C is preferably larger than 10 mN/m, more preferably larger than 10 mN/m and smaller than 100 mN/m, further preferably larger than 15 mN/m and smaller than 60 mN/m, from the standpoint of film formability.

The method of removing a solvent includes drying methods such as a hot air drying method, an infrared heating drying method, a flash lamp annealing drying method, a pressured-reduced drying method and the like.

### <Electronic device>

The electronic device of the present invention is an electronic device having a first electrode and a second electrode and having an organic semiconductor layer between the first electrode and the second electrode, wherein the organic semiconductor layer contains the film of the present invention.

The film of the present invention can transport electrons and holes injected from electrodes or charges generated by light absorption when the film is used in a device since the film can exert high electron and/or hole transportability. The film can be suitably used in various electronic devices such as a photoelectric conversion device, an organic film transistor and the like utilizing these properties. These devices will be illustrated individually below.

### <Photoelectric conversion device>

The photoelectric conversion device of the present invention is a photoelectric conversion device having a first electrode and a second electrode and having a film fabricated using the ink composition of the present invention as an active layer between the above-described first electrode and the above-described second electrode. It is preferable that at least one of the first electrode and the second electrode is transparent or semi-transparent.

One embodiment of the photoelectric conversion device of the present invention is a photoelectric conversion device having a first electrode and a second electrode and having two or more active layers between the above-described first electrode and the above-described second electrode, wherein at least one of the active layers is a film fabricated using the ink composition of the present invention.

Another embodiment of the photoelectric conversion device of the present invention is a photoelectric conversion device having a first electrode and a second electrode and having a first active layer containing a film fabricated using the ink composition of the present invention between the above-described first electrode and the above-described second electrode and a second active layer containing an electron accepting compound such as a fullerene derivative and the like adjacent to first active layer.

The photoelectric conversion device of the present invention is usually formed on a substrate. This substrate may advantageously one which does not chemically change when an electrode is formed and a layer of an organic substance is formed. The material of the substrate includes, for example, glass, plastics, polymer films and silicon. In the case of an opaque substrate, it is preferable that the opposite electrode (namely, an electrode far from the substrate) is transparent or semi-transparent.

The transparent or semi-transparent electrode material includes an electrically conductive metal oxide film, a semi-transparent metal film and the like. Specifically, electrically conductive materials made of indium oxide, zinc oxide and tin oxide and composites thereof: indium•tin•oxide (ITO), indium•zinc•oxide and the like; and NESA, gold, platinum, silver and copper are used, and preferable are ITO, indium•zinc•oxide and tin oxide. The electrode fabrication method includes a vacuum vapor deposition method, a sputtering method, an ion plating method, a plating method and the like.

As the electrode material, transparent conductive films made of an organic substance such as polyaniline and its derivatives, polythiophene and its derivatives and the like may be used.

One electrode may not be transparent or semi-transparent, and, metals, electrically conductive polymers and the like can be used as the electrode material of the electrode. Specific examples of the electrode material include metals such as lithium, sodium, potassium, rubidium, cesium, magnesium, calcium, strontium, barium, aluminum, scandium, vanadium, zinc, yttrium, indium, cerium, samarium, europium, terbium, ytterbium and the like, and alloys composed of two or more of them, or alloys composed of one or more of the above-described metals and one or more metals selected from the group consisting of gold, silver, platinum, copper, manganese, titanium, cobalt, nickel, tungsten and tin; graphite, graphite intercalation compounds, polyaniline and its derivatives, and polythiophene and its derivatives. The alloy includes a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy and the like.

As a means for improving photoelectric conversion efficiency, an additional intermediate layer other than the active layer may be used. The material of the intermediate layer includes halides of alkali metals and alkaline earth metals such as lithium fluoride and the like, oxides such as titanium oxide and the like, PEDOT (poly-3,4-ethylenedioxythiophene) and the like.

### <Production method of photoelectric conversion device>

The preferable method of producing a photoelectric conversion device is a method of producing a photoelectric conversion device having a first electrode and a second electrode and having an active layer between the first electrode and the second electrode, comprising a step of applying the ink composition of the present invention on the first electrode by an application method to form an active layer and a step of forming the second electrode on the active layer.

### <Organic transistor>

The film fabricated using the ink composition of the present invention can be used also in an organic film transistor. The organic film transistor includes one having a constitution having a source electrode and a drain electrode, an organic semiconductor layer (active layer) acting as a current pathway between these electrodes, and a gate electrode controlling the quantity of current passing through the current pathway, in which the organic semiconductor layer is constituted of the film described above (organic film). Such an organic film transistor includes an electric field effect transistor, an electrostatic induction transistor and the like.

The electric field effect organic film transistor preferably has a source electrode and a drain electrode, an organic semiconductor layer (active layer) acting as a current pathway between these electrodes, a gate electrode controlling the quantity of current passing through the current pathway, and an insulation layer disposed between the organic semiconductor layer and the gate electrode. Particularly, it is preferable that a source electrode and a drain electrode are disposed in contact with an organic semiconductor layer (active layer), and further, a gate electrode is disposed sandwiching an insulation layer in contact with the organic semiconductor layer. In the electric field effect organic film transistor, the organic semiconductor layer is constituted of an organic film containing a film fabricated using the ink composition of the present invention.

The electrostatic induction organic film transistor preferably has a source electrode and a drain electrode, an organic semiconductor layer (active layer) acting as a current pathway between these electrodes, and a gate electrode controlling the quantity of current passing through the current pathway, wherein this gate electrode is disposed in the organic semiconductor layer. Particularly, it is preferable that a source electrode, a drain electrode and, a gate electrode disposed in an organic semiconductor layer are disposed in contact with the organic semiconductor layer. Here, the gate electrode may have a structure by which a current pathway flowing from a source electrode to a drain electrode can be formed and the quantity of current passing through the current pathway can be controlled by voltage applied to the gate electrode, and for example, a comb-shaped electrode is mentioned. Also in the electrostatic induction organic film transistor, the organic semiconductor layer is constituted of an organic film containing the compound of the present invention.

### <Use of device>

In the photoelectric conversion device of the present invention, when light such as solar light and the like is applied from a transparent or semi-transparent electrode, photovoltaic power is generated between electrodes, thus, the photoelectric conversion device can be operated as an organic film solar battery. By integrating a plurality of organic film solar batteries, they can also be used as an organic film solar battery module.

By applying light from a transparent or semi-transparent electrode under condition of application of voltage between electrodes or no application of voltage, photocurrent flows, thus the photoelectric conversion device can be operated as an organic optical sensor. By integrating a plurality of organic optical sensors, they can also be used as an organic image sensor.

The organic film transistor described above can be used, for example, as a picture element driving device used for controlling pixels of an electrophoresis display, a liquid crystal display, an organic electroluminescent display and the like and for controlling homogeneity of screen luminance and screen rewriting rate.

### <Solar battery module>

The organic film solar battery can take basically the same module structure as that of a conventional solar battery module. A solar battery module generally takes a structure in which a cell is constituted on a supporting substrate made of a metal, ceramic or the like, its upper side is covered with a filling resin, protective glass or the like and light is incorporated from the opposite side of the supporting substrate, however, it is also possible to provide a structure in which a transparent material such as reinforced glass and the like is used as a supporting substrate, a cell is constituted on this and light is incorporated from the side of the transparent supporting substrate. Specifically, module structures called super straight type, sub straight type or potting type, substrate integrated module structures used in amorphous silicon solar batteries, and the like, are known. Also an organic film solar battery produced by using the compound of the present invention can appropriately adopt these module structures depending on the use object, the use place and environments.

A typical super straight type or sub straight type module has a structure in which cells are placed at regular intervals between supporting substrates one or both of which are transparent and having undergone an antireflection treatment, mutually adj acent cells are connected via a metal lead, flexible wiring or the like, a collecting electrode is placed at the exterior edge, and generated electric power is taken out to the outside. Between a substrate and a cell, various kinds of plastic materials such as ethylene vinyl acetate (EVA) and the like depending on the object may be used in the form of a film or a filling resin, for protection of the cell and improvement of power collecting efficiency.

In the case of use at a place where the surface is not required to be covered with a hard material such as a place receiving little impact from the outside, it is possible that the surface protective layer is constituted of a transparent plastic film or the above-described filling resin is hardened to impart a protective function, and a supporting substrate on one side is deleted. The circumference of the supporting substrate is fixed in the form of sandwich by a metal frame and the aperture between the supporting substrate and the frame is sealed with a sealing material, for ensuring internal sealing and module stiffness. When a flexible material is used as a cell itself or a supporting substrate, a filling material and a sealing material, it is also possible to constitute a solar battery on a curved surface. In the case of a solar battery using a flexible supporting body such as a polymer film and the like, it is possible that cells are formed in series while feeding a supporting body in the form of a roll, cut into desired size, then, the periphery is sealed with a flexible and moisture-proof material, thus, a battery body is fabricated. Also, a module structure called "SCAF" described in Solar Energy Materials and Solar Cells, 48, pp. 383-391 can be adopted. Further, a solar battery using a flexible supporting body can also be adhered and fixed to curved glass or the like and used.

### EXAMPLES

Examples are shown below for illustrating the present invention further in detail, but the present invention is not limited to them.

In the present examples, P-type semiconductor materials and N-type semiconductor materials described in the following tables were used.

| | number | chemical structure |
|---|---|---|
| P-type semiconductor material | P-1 | 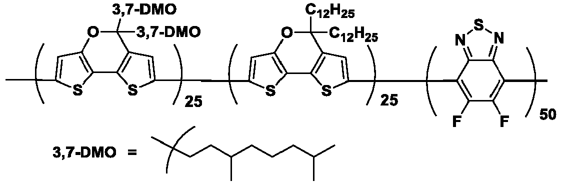 |
| P-type semiconductor material | P-2 | 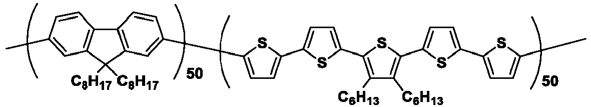 |
| P-type semiconductor material | P-3 | 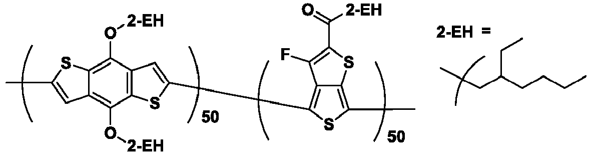 |
| P-type semiconductor material | P-4 | 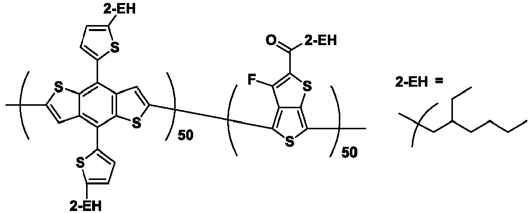 |
| P-type semiconductor material | P-5 | 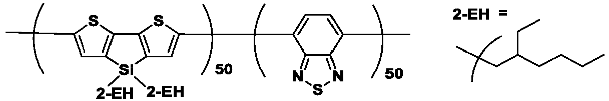 |
| P-type semiconductor material | P-6 | 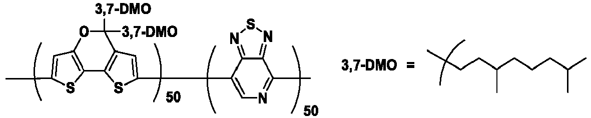 |
| N-type semiconductor material | N-1 | 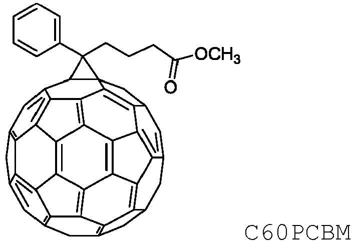 |
| N-type semiconductor material | N-2 | 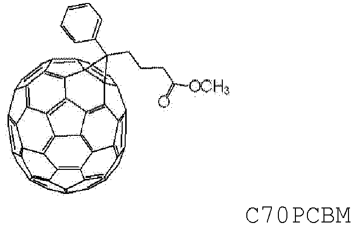 |

P-1 was synthesized by reference to a method described in WO2013051676.

P-2 was synthesized by reference to a method described in JP-A No. 2010-74127.

As P-3, PTB7 (trade name: lot. YY6156) manufactured by 1-material was used.

As P-4, PCE10 (trade name: lot. YY7132) manufactured by 1-material was used.

As P-5, PSBTBT (trade name: lot. S9066-140930002) manufactured by Lumtec was used.

P-6 was synthesized by reference to a method described in WO2011052709.

P-7 was synthesized by reference to a method described in JP-A No. 2014-31362.

As N-1, E100 (trade name: lot. 11A0082-A) manufactured by Frontier Carbon Corporation was used.

As N-2, ADS71BFA (trade name: lot. 11F034E) manufactured by American Dye Source, Inc. was used.

The hydrogen bond Hansen parameter (H), the polarity Hansen parameter (P), the dispersion Hansen parameter (D) and the boiling point (bp) of solvents used in the present examples are as shown in the following tables.

| Name of solvent | H (MPa^{0.5}) | P (MPa^{0.5}) | D (MPa^{0.5}) | bp (°C) |
|---|---|---|---|---|
| toluene | 2.0 | 1.4 | 18 | 111 |
| p-xylene | 3.1 | 1.0 | 17.8 | 138 |
| o-xylene | 3.1 | 1.0 | 17.8 | 144 |
| m-xylene | 2.8 | 2.6 | 17.8 | 145 |
| anisole | 6.9 | 4.4 | 17.8 | 154 |
| cyclohexanone | 5.1 | 8.4 | 17.8 | 155 |
| mesitylene | 0.6 | 0.6 | 18.0 | 165 |
| pseudocumene | 1.0 | 1.0 | 18.0 | 169 |
| sec-butylbenzene | 2.1 | 1.4 | 17.1 | 179 |
| o-dichlorobenzene | 3.3 | 6.3 | 19.2 | 180 |
| salicylaldehyde | 12 | 10.5 | 19 | 196 |
| 1,2,3,5-tetramethylbenzene | 0.5 | 0.5 | 18.6 | 198 |
| methyl benzoate | 4.7 | 8.2 | 18.9 | 200 |
| acetophenone | 4.0 | 9.0 | 18.8 | 202 |
| propiophenone | 3.8 | 6.3 | 18.2 | 208 |
| tetralin | 2.9 | 2.0 | 19.6 | 208 |
| butyl benzoate | 5.5 | 5.6 | 18.3 | 250 |
| diphenyl ether | 4.0 | 3.4 | 19.4 | 258 |
| 1-methoxynaphthalene | 5.6 | 4.6 | 19.6 | 262 |
| dibenzyl ether | 5.2 | 3.4 | 19.6 | 288 |
| benzyl benzoate | 5.2 | 5.1 | 20.0 | 323 |

### <Example 1>

### (Preparation of ink composition)

A mixed solvent was prepared by using o-xylene as a first solvent and acetophenone as a second solvent and by adjusting the weight ratio of the first solvent to the second solvent to 97:3. P-1 as a P-type semiconductor material was mixed in an amount of 0.5% by weight with respect to the total weight of the composition and N-1 as an N-type semiconductor material was mixed in an amount of 1.0% by weight with respect to the total weight of the composition into the above-described mixed solvent, and the mixture was stirred at 85°C for 3 hours, then, filtrated through a PTFE filter having a pore diameter of 5 um, to obtain an ink composition (I-1).

### <Examples 2 to 15 and Preparation Examples 1 to 3>

Ink compositions (I-2) to (I-15) and (C-1) to (C-5) were fabricated using the same amounts of the P-type semiconductor material and the N-type semiconductor material as in Example 1, excepting that solvents shown in the following table were used as the first solvent, the second solvent and the third solvent.

| | ink composition | first solvent | second solvent third solvent is described in <> | solvent mixing ratio % by weight | dH (MPa^{0.5}) | dP (MPa^{0.5}) | dbp (°C) |
|---|---|---|---|---|---|---|---|
| Example 1 | I-1 | o-xylene | acetophenone | 97:3 | 0.9 | 8.0 | 58 |
| Example 2 | I-2 | o-xylene | butyl benzoate | 97:3 | 2.4 | 4.6 | 106 |
| Example 3 | I-3 | o-xylene | benzyl benzoate | 97:3 | 2.1 | 4.1 | 179 |
| Example 4 | I-4 | o-xylene | methyl benzoate | 97:3 | 1.6 | 7.2 | 56 |
| Example 5 | I-5 | o-xylene | dibenzyl ether | 97:3 | 2.1 | 2.4 | 144 |
| Example 6 | I-6 | pseudocumene | acetophenone | 97:3 | 3.0 | 8.0 | 33 |
| Example 7 | I-7 | pseudocumene | propiophenone | 97:3 | 2.8 | 5.3 | 39 |
| Example 8 | I-8 | pseudocumene | butyl benzoate | 97:3 | 4.5 | 4.6 | 81 |
| Example 9 | I-9 | pseudocumene | benzyl benzoate | 97:3 | 4.2 | 4.1 | 154 |
| Example 10 | I-10 | pseudocumene | methyl benzoate | 97:3 | 3.7 | 7.2 | 31 |
| Example 11 | I-11 | pseudocumene | diphenyl ether | 97:3 | 3.0 | 2.4 | 89 |
| Preparation Example 12 | I-12 | pseudocumene | dibenzyl ether | 97:3 | 4.2 | 2.4 | 119 |
| Example 13 | I-13 | pseudocumene | methyl benzoate <acetophenone> | 85:10:5 | 3.7 | 7.2 | 31 |
| Example 14 | I-14 | tetralin | butyl benzoate | 97:3 | 2.6 | 3.6 | 42 |
| Example 15 | I-15 | tetralin | dibenzyl ether | 97:3 | 2.3 | 3.1 | 80 |
| Preparation Example 1 | C-1 | o-xylene | - | - | - | - | - |
| Preparation Example 2 | C-2 | o-xylene | pseudocumene | 97:3 | -2.1 | 0 | 25 |
| Preparation Example 3 | C-3 | pseudocumene | - | - | - | - | - |
| Preparation Example 4 | C-4 | cyclohexanon e | pseudocumene | 3:97 | -4.1 | -7.4 | 14 |
| Preparation Example 5 | C-5 | pseudocumene | salicylaldehyde | 97:3 | 11 | 9.5 | 27 |

In the table, dH represents a difference (H2-H1) between the hydrogen bond Hansen parameter (H1) of the first solvent and the hydrogen bond Hansen parameter (H2) of the second solvent.

dP represents a difference (P2-P1) between the polarity Hansen parameter (P1) of the first solvent and the polarity Hansen parameter (P2) of the second solvent.

dbp represents a difference (bp2-bp1) between the boiling point (bp1) of the first solvent and the boiling point (bp2) of the second solvent.

### <Example 16>

### (Fabrication and evaluation of photoelectric conversion device)

A glass substrate attached with an ITO film with a thickness of 150 nm by a sputtering method was surface-treated by treating with ozone and UV. A suspension (manufactured by HC Starck V-tech, Bytron P TP AI4083) prepared by dissolving poly(3,4)ethylenedioxythiophene/polystyrenesulfonic acid in water was filtrated through a filter having a pore size of 0.5 um. The suspension after filtration was spin-coated on the ITO side of the substrate to form a film with a thickness of 70 nm. Then, the film was dried on a hot plate at 200°C for 10 minutes in an air atmosphere, to form an organic layer. Next, the ink composition (I-1) was spin-coated on the organic layer, then, dried in a nitrogen atmosphere, to form an active layer. The thickness after drying was about 100 nm. Thereafter, a film of Ca was formed with a thickness of about 4 nm on the active layer, then, a film of Al was formed with a thickness of about 70 nm, to form an electrode, in a resistance heating vapor deposition apparatus. Then, a sealing treatment was performed by adhering the glass substrate using an epoxy resin (rapid curing type Araldite) as a sealing agent, to obtain a photoelectric conversion device. The shape of the resultant photoelectric conversion device was 2 mm × 2 mm square. The resultant photoelectric conversion device was irradiated with constant light using a solar simulator (manufactured by Bunkoukeiki Co., Ltd., trade name: type CEP-2000, irradiance: 100 mW/cm²), and the current and the voltage generated were measured, and Jsc (short circuit current density) was determined.

The short circuit current density (Jsc) was 14.67 mA/cm².

### <Examples 17 to 30 and Comparative Examples 1 to 5>

Photoelectric conversion devices were fabricated and evaluated in the same manner as in Example 6, excepting that ink compositions (I-2) to (I-15) and (C-1) to (C-5) were used. The results are shown in the following table.

| | ink composition | short circuit current density (mA/cm²) |
|---|---|---|
| Example 16 | I-1 | 14.67 |
| Example 17 | I-2 | 16.48 |
| Example 18 | I-3 | 16.48 |
| Example 19 | I-4 | 15.78 |
| Example 20 | I-5 | 15.77 |
| Example 21 | I-6 | 14.97 |
| Example 22 | I-7 | 15.88 |
| Example 23 | I-8 | 14.90 |
| Example 24 | I-9 | 15.57 |
| Example 25 | I-10 | 16.20 |
| Example 26 | I-11 | 15.64 |
| Example 27 | I-12 | 15.86 |
| Example 28 | I-13 | 13.64 |
| Example 29 | I-14 | 16.12 |
| Example 30 | I-15 | 15.84 |
| Comparative Example 1 | C-1 | 8.62 |
| Comparative Example 2 | C-2 | 8.56 |
| Comparative Example 3 | C-3 | 9.31 |
| Comparative Example 4 | C-4 | 9.89 |
| Comparative Example 5 | C-5 | 8.11 |

The photoelectric conversion devices of Examples 16 to 30 had high short circuit current density as compared with the photoelectric conversion devices of Comparative Examples 1 to 5.

### <Examples 31 to 33 and Preparation Examples 6 to 7>

Ink compositions (I-16) to (I-18) and (C-6) to (C-7) were fabricated in the same manner as in Example 1, using solvents described in the following table as the first solvent and the second solvent and using P-1 (0.5% by weight with respect to the total amount of the composition) as the P-type semiconductor material and N-2 (1.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 31 | I-16 | o-xylene | 1-methoxy naphthalene | 97:3 | 2.5 | 3.6 | 118 |
| Example 32 | I-17 | o-xylene | dibenzyl ether | 97:3 | 2.1 | 2.4 | 144 |
| Example 33 | I-18 | p-xylene | 1-methoxy naphthalene | 97:3 | 2.5 | 3.6 | 124 |
| Preparation Example 6 | C-6 | o-xylene | - | - | - | - | - |
| Preparation Example 7 | C-7 | p-xylene | - | - | - | - | - |

### <Examples 34 to 36 and Comparative Examples 6 to 7>

Photoelectric conversion devices were fabricated and evaluated in the same manner as in Example 16, excepting that ink compositions (I-31) to (I-33) and (C-6) to (C-7) were used. The results are shown in the following table.

| | ink composition | short circuit current density |
|---|---|---|
| | | (mA/cm²) |
| Example 34 | I-16 | 14.59 |
| Example 35 | I-17 | 14.84 |
| Example 36 | I-18 | 15.89 |
| Comparative Example 6 | C-6 | 1.76 |
| Comparative Example 7 | C-7 | 1.06 |

The photoelectric conversion devices of Examples 34 to 36 had high short circuit current density as compared with the photoelectric conversion devices of Comparative Examples 6 to 7.

### <Examples 37 TO 38 are reference examples not forming part of the present invention and Preparation Example 8>

Ink compositions (I-19) to (I-20) and (C-8) were fabricated in the same manner as in Example 1, using solvents described in the following table as the first solvent and the second solvent and using P-2 (0.5% by weight with respect to the total amount of the composition) as the P-type semiconductor material and N-1 (1.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 37 | I-19 | o-xylene | 1-methoxy naphthalene | 97:3 | 2.5 | 3.6 | 118 |
| Example 38 | I-20 | o-xylene | benzyl benzoate | 97:3 | 2.1 | 4.1 | 179 |
| Preparation Example 8 | C-8 | o-xylene | - | - | - | - | - |

### <Reference Examples 39 to 40 not forming part of the present invention and Comparative Example 6>

Photoelectric conversion devices were fabricated and evaluated in the same manner as in Example 16, excepting that ink compositions (I-37) to (I-38) and (C-8) were used. The results are shown in the following table.

| | ink composition | short circuit current density |
|---|---|---|
| | | (mA/cm²) |
| Example 39_{*} | I-19 | 5.17 |
| Example 40* | I-20 | 4.35 |
| Comparative Example 8 | C-8 | 2.82 |

| | | |
|---|---|---|
| * Reference Examples not forming part of the present invention. | | |

The photoelectric conversion devices of Reference Examples 39 to 40 had high short circuit current density as compared with the photoelectric conversion device of Comparative Example 8.

### <Reference Example 41 not forming part of the present invention and Preparation Examples 9 to 11>

Ink compositions (I-21) and (C-9) to (C-11) were fabricated in the same manner as in Example 1, using solvents described in the following table as the first solvent and the second solvent and using P-2 (0.5% by weight with respect to the total amount of the composition) as the P-type semiconductor material and N-1 (1.5% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 41 | I-21 | m-xylene | 1-methoxy naphthalene | 90:10 | 2.8 | 2.0 | 117 |
| Preparation Example 9 | C-9 | toluene | - | - | - | - | - |
| Preparation Example 10 | C-10 | toluene | anisole | 95:5 | 4.9 | 3 | 43 |
| Preparation Example 11 | C-11 | m-xylene | - | - | - | - | - |

### <Reference Example 42 not forming part of the present invention and Comparative Examples 9 to 11>

Photoelectric conversion devices were fabricated and evaluated in the same manner as in Example 16, excepting that ink compositions (I-21) and (C-9) to (C-11) were used. The results are shown in the following table.

| | ink composition | short circuit current density |
|---|---|---|
| | | (mA/cm²) |
| Example 42 _{*} | I-21 | 4.98 |
| Comparative Example 9 | C-9 | 1.47 |
| Comparative Example 10 | C-10 | 1.83 |
| Comparative Example 11 | C-11 | 1.82 |

| | | |
|---|---|---|
| * Reference Example not forming part of the present invention. | | |

The photoelectric conversion device of Reference Example 42 had high short circuit current density as compared with the photoelectric conversion devices of Comparative Examples 9 to 11.

### <Examples 43 to 44 and Preparation Example 12>

Ink compositions (I-22) to (I-23) and (C-12) were fabricated in the same manner as in Example 1, using solvents described in the following table as the first solvent and the second solvent and using P-3 (0.5% by weight with respect to the total amount of the composition) as the P-type semiconductor material and N-2 (0.75% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 43 | I-22 | pseudocumene | 1-methoxy naphthalene | 97:3 | 4.6 | 3.6 | 93 |
| Example 44 | I-23 | pseudocumene | benzyl benzoate | 97:3 | 2.1 | 2.4 | 144 |
| Preparation Example 12 | C-12 | pseudocumene | - | - | - | - | - |

### <Examples 45 to 46 and Comparative Example 12>

Photoelectric conversion devices were fabricated and evaluated in the same manner as in Example 16, excepting that ink compositions (I-22) to (I-23) and (C-12) were used. The results are shown in the following table.

| | ink composition | short circuit current density |
|---|---|---|
| | | (mA/cm²) |
| Example 45 | I-22 | 12.13 |
| Example 46 | I-23 | 9.05 |
| Comparative Example 12 | C-12 | 4.72 |

The photoelectric conversion devices of Examples 45 to 46 had high short circuit current density as compared with the photoelectric conversion device of Comparative Example 12.

### <Examples 47 to 48 and Preparation Example 13>

Ink compositions (I-24) to (I-25) and (C-13) were fabricated in the same manner as in Example 1, using solvents described in the following table as the first solvent and the second solvent and using P-4 (0.5% by weight with respect to the total amount of the composition) as the P-type semiconductor material and N-1 (1.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 47 | I-24 | sec-butyl benzene | methyl benzoate | 90:10 | 2.6 | 6.8 | 21 |
| Example 48 | I-25 | sec-butyl benzene | benzyl benzoate | 90:10 | 3.1 | 3.7 | 144 |
| Preparation Example 13 | C-13 | sec-butyl benzene | - | - | - | - | - |

### <Examples 49 to 50 and Comparative Example 13>

Photoelectric conversion devices were fabricated and evaluated in the same manner as in Example 16, excepting that ink compositions (I-24) to (I-25) and (C-13) were used. The results are shown in the following table.

| | ink composition | short circuit current density |
|---|---|---|
| | | (mA/cm²) |
| Example 49 | I-24 | 12.44 |
| Example 50 | I-25 | 8.76 |
| Comparative Example 13 | C-13 | 5.01 |

The photoelectric conversion devices of Examples 49 to 50 had high short circuit current density as compared with the photoelectric conversion device of Comparative Example 13.

### <Example 51 and Preparation Example 14>

Ink compositions (I-27) and (C-14) were fabricated in the same manner as in Example 1, using solvents described in the following table as the first solvent and the second solvent and using P-5 (1.0% by weight with respect to the total amount of the composition) as the P-type semiconductor material and N-1 (1.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 51 | I-26 | pseudocumene | o-dichloro benzene | 70:30 | 2.3 | 5.3 | 11 |
| Preparation Example 14 | C-14 | pseudocumene | - | - | - | - | - |

<Example 52 and Comparative Example 14>

Photoelectric conversion devices were fabricated and evaluated in the same manner as in Example 16, excepting that ink compositions (I-26) and (C-14) were used. The results are shown in the following table.

| | ink composition | short circuit current density |
|---|---|---|
| | | (mA/cm²) |
| Example 52 | I-26 | 6.21 |
| Comparative Example 14 | C-14 | 4.14 |

The photoelectric conversion device of Example 52 had high short circuit current density as compared with the photoelectric conversion device of Comparative Example 14.

### <Examples 53 to 54 and Preparation Example 15>

Ink compositions (I-27) to (I-28) and (C-15) were fabricated in the same manner as in Example 1, using solvents described in the following table as the first solvent and the second solvent and using P-6 (1.0% by weight with respect to the total amount of the composition) as the P-type semiconductor material and N-1 (2.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 53 | I-27 | pseudocumene | propiophenone | 95:5 | 2.8 | 5.3 | 39 |
| Example 54 | I-28 | pseudocumene | methyl benzoate | 90:10 | 3.7 | 7.2 | 31 |
| Preparation Example 10 | C-15 | pseudocumene | - | - | - | - | - |

### <Examples 55 to 56 and Comparative Example 15>

Photoelectric conversion devices were fabricated and evaluated in the same manner as in Example 16, excepting that ink compositions (I-27) to (I-28) and (C-15) were used. The results are shown in the following table.

| | ink composition | short circuit current density |
|---|---|---|
| | | (mA/cm²) |
| Example 55 | I-27 | 11.97 |
| Example 56 | I-28 | 11.61 |
| Comparative Example 15 | C-15 | 3.03 |

The photoelectric conversion devices of Examples 55 to 56 had high short circuit current density as compared with the photoelectric conversion device of Comparative Example 15.

### <Example 57 and Preparation Example 16>

Ink compositions (I-29) and (C-16) were fabricated in the same manner as in Example 1, using solvents described in the following table as the first solvent and the second solvent and using P-7 (1.0% by weight with respect to the total amount of the composition) as the P-type semiconductor material and N-1 (2.0% by weight with respect to the total amount of the composition) as the N-type semiconductor material.

| | ink composition | first solvent | second solvent | solvent mixing ratio % by weight | dH (MPa^{0.5}) | dP (MPa^{0.5}) | dbp (°C) |
|---|---|---|---|---|---|---|---|
| Example 57 | I-29 | tetralin | 1-methoxy naphthalene | 95:5 | 2.7 | 2.0 | 54 |
| Preparation Example 16 | C-16 | tetralin | - | - | - | - | - |

### <Example 58 and Comparative Example 16>

Photoelectric conversion devices were fabricated and evaluated in the same manner as in Example 16, excepting that ink compositions (I-29) and (C-16) were used. The results are shown in the following table.

| | ink composition | short circuit current density |
|---|---|---|
| | | (mA/cm²) |
| Example 58 | I-29 | 2.07 |
| Comparative Example 16 | C-16 | 0.69 |

The photoelectric conversion device of Example 58 had high short circuit current density as compared with the photoelectric conversion device of Comparative Example 16.

### Industrial Applicability

The present invention can provide an ink composition capable of fabricating a photoelectric conversion device with which high short circuit current density is obtained, by containing two kinds of solvents the boiling point and the hydrogen bond Hansen solubility parameter of which are prescribed.

## Claims

1. An ink composition comprising a P-type semiconductor material, an N-type semiconductor material and two or more solvents including a first solvent and a second solvent, wherein
the total amount of the first solvent and the second solvent is 70% by weight or more with respect to 100% by weight of all the solvents contained in the ink composition;
the boiling point of the first solvent is lower than the boiling point of the second solvent;
the boiling point of the first solvent is 120°C or more and 400°C or less; and
the hydrogen bond Hansen solubility parameter H1 (MPa^{0.5}) of the first solvent and the hydrogen bond Hansen solubility parameter H2 (MPa^{0.5}) of the second solvent are in the relation of 0.5 ≤ (H2-H1) ≤ 5.0;
the first solvent is an aromatic hydrocarbon solvent;
the second solvent is an ether solvent, a ketone solvent or an ester solvent;
the amount of the first solvent is the largest among all the solvents; and
**characterized in that** the P-type semiconductor material is a polymer compound comprising a repeating unit represented by the following (I-1) and/or the following formula (II-1) to (II-4) or (II-6) : 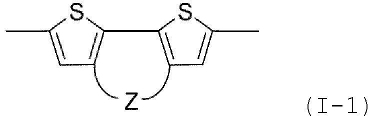
wherein, Z represents a divalent group represented by (Z-1) to (Z-7), 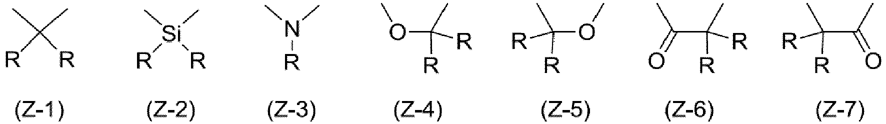 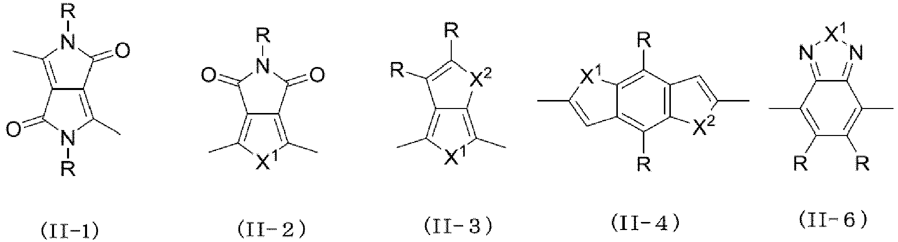
wherein,
X¹ and X² each independently represent an oxygen atom or a sulfur atom,
R represents a hydrogen atom, a halogen atom, an alkyl group, an aryl group, an alkoxy group, an aryloxy group, an alkylthio group, an arylthio group, a mono-valent heterocyclic group, a substituted amino group, an acyl group, an imine residue, a substituted amide group, an acid imide group, a substituted carboxyl group, an alkenyl group, an alkynyl group, a cyano group or a nitro group.

2. The ink composition according to Claim 1, wherein the amount of the second solvent is the second largest among all the solvents.

3. The ink composition according to Claim 1 or Claim 2, wherein the polarity Hansen solubility parameter P1 (MPa^{0.5}) of the first solvent and the polarity Hansen solubility parameter P2 (MPa^{0.5}) of the second solvent are in the relation of 1.0 ≤ (P2-P1) ≤ 9.0.

4. The ink composition according to any one of Claims 1 to 3, wherein the difference between the polarity Hansen solubility parameter P1 (MPa^{0.5}) of the first solvent and the polarity Hansen solubility parameter P2 (MPa^{0.5}) of the second solvent is in the range of 2.0 ≤ (P2-P1) ≤ 9.0.

5. The ink composition according to any one of Claims 1 to 4, wherein the P-type semiconductor material is a polymer compound comprising a repeating unit represented by formula (I-1), (II-1), (II-3), (II-4) or (II-6), wherein the repeating unit represented by formula (I-1) is selected from constitutional units represented by the formula (501) and the formula (504): 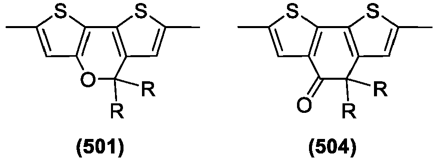 wherein R is as defined in claim 1, and when there are two groups R, they may be the same or different.

6. A process for preparing a film using the ink composition according to any one of Claims 1 to 5.

7. A process for preparing an organic photoelectric conversion device having a first electrode and a second electrode and having a film as an active layer between said first electrode and said second electrode, wherein the process comprises preparing the film using the ink composition according to any one of Claims 1 to 5.

8. A process for preparing a solar battery module or sensor having an organic photoelectric conversion device, the organic photoelectric conversion device having a first electrode and a second electrode and having a film as an active layer between said first electrode and said second electrode, wherein the process comprises preparing the film using the ink composition according to any one of Claims 1 to 5.

## Patentansprüche

1. Tintenzusammensetzung, umfassend ein Halbleitermaterial vom P-Typ, ein Halbleitermaterial vom N-Typ und zwei oder mehr Lösungsmittel, die ein erstes Lösungsmittel und ein zweites Lösungsmittel einschließen, wobei
die Gesamtmenge des ersten Lösungsmittels und des zweiten Lösungsmittels 70 Gew.-% oder mehr, bezogen auf 100 Gew.-% aller in der Tintenzusammensetzung enthaltenen Lösungsmittel, beträgt;
der Siedepunkt des ersten Lösungsmittels niedriger ist als der Siedepunkt des zweiten Lösungsmittels;
der Siedepunkt des ersten Lösungsmittels 120 °C oder mehr und 400 °C oder weniger beträgt; und
der Wasserstoffbindungs-Löslichkeitsparameter nach Hansen H1 (MPa^{0,5}) des ersten Lösungsmittels und der Wasserstoffbindungs-Löslichkeitsparameter nach Hansen H2 (MPa^{0,5}) des zweiten Lösungsmittels in der Relation 0,5 ≤ (H2-H1) ≤ 5,0 stehen;
das erste Lösungsmittel ein aromatisches Kohlenwasserstoff-Lösungsmittel ist;
das zweite Lösungsmittel ein Ether-Lösungsmittel, ein Keton-Lösungsmittel oder ein Ester-Lösungsmittel ist;
die Menge des ersten Lösungsmittels unter all den Lösungsmitteln die größte ist; und
**dadurch gekennzeichnet, dass**
das Halbleitermaterial vom P-Typ eine Polymerverbindung ist, die eine durch die folgende Formel (1-1) und/oder die folgenden Formeln (II-1) bis (II-4) oder (II-6) dargestellte sich wiederholende Einheit umfasst: 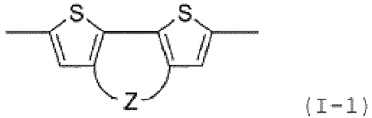
wobei Z eine zweiwertige Gruppe darstellt, die durch (Z-1) bis (Z-7) dargestellt ist, 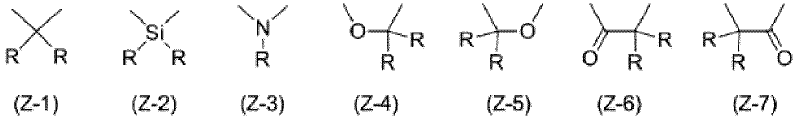 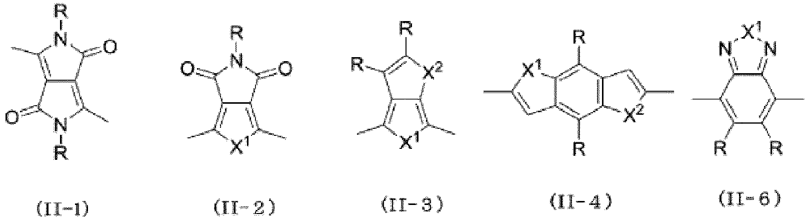
wobei
X¹ und X² jeweils unabhängig ein Sauerstoffatom oder ein Schwefelatom darstellen,
R ein Wasserstoffatom, ein Halogenatom, eine Alkylgruppe, eine Arylgruppe, eine Alkoxygruppe, eine Aryloxygruppe, eine Alkylthiogruppe, eine Arylthiogruppe, eine einwertige heterocyclische Gruppe, eine substituierte Aminogruppe, eine Acylgruppe, einen Iminrest, eine substituierten Amidgruppe, eine Säureimidgruppe, eine substituierte Carboxylgruppe, eine Alkenylgruppe, eine Alkinylgruppe, eine Cyanogruppe oder eine Nitrogruppe darstellt.

2. Tintenzusammensetzung nach Anspruch 1, wobei die Menge des zweiten Lösungsmittels unter all den Lösungsmitteln die zweitgrößte ist.

3. Tintenzusammensetzung nach Anspruch 1 oder Anspruch 2, wobei der Polaritäts-Löslichkeitsparameter nach Hansen P1 (MPa^{0,5}) des ersten Lösungsmittels und der Polaritäts-Löslichkeitsparameter nach Hansen P2 (MPa^{0,5}) des zweiten Lösungsmittels in der Relation 1,0 ≤ (P2-P1) ≤ 9,0 stehen.

4. Tintenzusammensetzung nach einem der Ansprüche 1 bis 3, wobei die Differenz zwischen dem Polaritäts-Löslichkeitsparameter nach Hansen P1 (MPa^{0,5}) des ersten Lösungsmittels und dem Polaritäts-Löslichkeitsparameter nach Hansen P2 (MPa^{0,5}) des zweiten Lösungsmittels im Bereich von 2,0 ≤ (P2-P1) ≤ 9,0 liegt.

5. Tintenzusammensetzung nach einem der Ansprüche 1 bis 4, wobei das Halbleitermaterial vom P-Typ eine Polymerverbindung ist, die eine von Formel (1-1), (II-1), (II-3), (II-4) oder (II-6) dargestellte sich wiederholende Einheit umfasst, wobei die von Formel (1-1) dargestellte sich wiederholende Einheit aus von Formel (501) und Formel (504) dargestellten konstituierenden Einheiten ausgewählt ist. 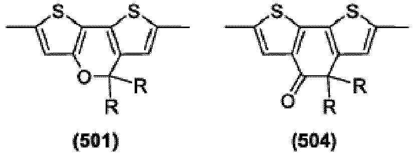 wobei R wie in Anspruch 1 definiert ist, und wenn es zwei R-Gruppen gibt, sie gleich oder unterschiedlich sein können.

6. Verfahren zum Herstellen eines Films unter Verwendung der Tintenzusammensetzung nach einem der Ansprüche 1 bis 5.

7. Verfahren zum Herstellen einer organischen photoelektrischen Umwandlungsvorrichtung mit einer ersten Elektrode und einer zweiten Elektrode, und mit einem Film als eine aktive Schicht zwischen der ersten Elektrode und der zweiten Elektrode, wobei das Verfahren das Herstellen des Films unter Verwendung der Tintenzusammensetzung nach einem der Ansprüche 1 bis 5 umfasst.

8. Verfahren zum Herstellen eines Solarbatteriemoduls oder Sensors mit einer organischen photoelektrischen Umwandlungsvorrichtung, wobei die organische photoelektrische Umwandlungsvorrichtung eine erste Elektrode und eine zweite Elektrode aufweist und einen Film als eine aktive Schicht zwischen der ersten Elektrode und der zweiten Elektrode aufweist, wobei das Verfahren das Herstellen des Films unter Verwendung der Tintenzusammensetzung nach einem der Ansprüche 1 bis 5 umfasst.

## Revendications

1. Composition d'encre comprenant un matériau semiconducteur de type P, un matériau semiconducteur de type N et deux solvants ou plus incluant un premier solvant et un deuxième solvant, dans laquelle
la quantité totale du premier solvant et du deuxième solvant est de 70 % en poids ou plus, par rapport à 100 % en poids de tous les solvants contenus dans la composition d'encre ;
le point d'ébullition du premier solvant est inférieur au point d'ébullition du deuxième solvant ;
le point d'ébullition du premier solvant est de 120 °C ou plus et de 400 °C ou moins ; et
le paramètre de solubilité Hansen de liaison hydrogène H1 (MPa^{0,5}) du premier solvant et le paramètre de solubilité Hansen de liaison hydrogène H2 (MPa^{0,5}) du deuxième solvant sont dans la relation de 0,5 ≤ (H2-H1) ≤ 5,0 ;
le premier solvant est un solvant hydrocarboné aromatique ;
le deuxième solvant est un solvant d'éther, un solvant de cétone ou un solvant d'ester ;
la quantité du premier solvant est la plus importante parmi tous les solvants ; et
**caractérisée en ce que** :
le matériau semiconducteur de type P est un composé polymère comprenant un motif répétitif représenté par la formule (I-1) suivante et/ou les formules (II-1) à (II-4) ou (II-6) suivantes : 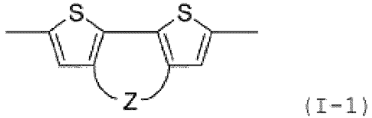
dans laquelle Z représente un groupe divalent représenté par (Z-1) à (Z-7), 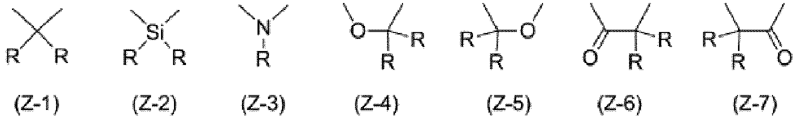 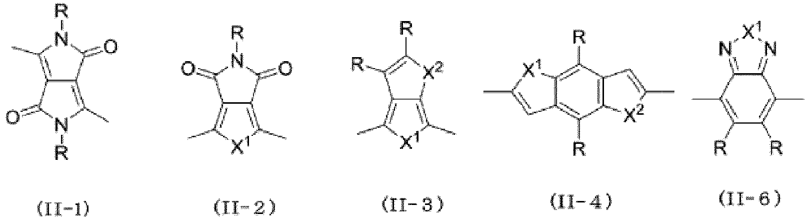
dans lesquelles,
X¹ et X² représentent chacun indépendamment un atome d'oxygène ou un atome de soufre,
R représente un atome d'hydrogène, un atome d'halogène, un groupe alkyle, un groupe aryle, un groupe alcoxy, un groupe aryloxy, un groupe alkylthio, un groupe arylthio, un groupe hétérocyclique monovalent, un groupe amino substitué, un groupe acyle, un résidu imine, un groupe amide substitué, un groupe imide d'acide, un groupe carboxyle substitué, un groupe alcényle, un groupe alcynyle, un groupe cyano ou un groupe nitro.

2. Composition d'encre selon la revendication 1, dans laquelle la quantité du deuxième solvant est la deuxième plus importante parmi tous les solvants.

3. Composition d'encre selon la revendication 1 ou la revendication 2, dans laquelle le paramètre de solubilité Hansen de polarité P1 (MPa^{0,5}) du premier solvant et le paramètre de solubilité Hansen de polarité P2 (MPa^{0,5}) du deuxième solvant sont dans la relation de 1,0 ≤ (P2-P1) ≤ 9,0.

4. Composition d'encre selon l'une quelconque des revendications 1 à 3, dans laquelle la différence entre le paramètre de solubilité Hansen de polarité P1 (MPa^{0,5}) du premier solvant et le paramètre de solubilité Hansen de polarité P2 (MPa^{0,5}) du deuxième solvant est dans la plage de 2,0 ≤ (P2-P1) ≤ 9,0.

5. Composition d'encre selon l'une quelconque des revendications 1 à 4, dans laquelle le matériau semiconducteur de type P est un composé polymère comprenant un motif répétitif représenté par la formule (I-1), (II-1), (II-3), (II-4) ou (II-6), dans laquelle le motif répétitif représenté par la formule (I-1) est sélectionné parmi les unités constitutives représentées par la formule (501) et la formule (504) : 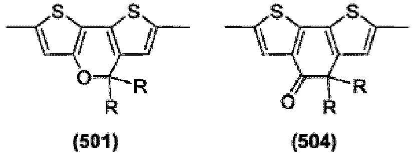 dans lesquelles R est tel que défini selon la revendication 1, et quand il y a deux groupes R, ils peuvent être identiques ou différents.

6. Processus de préparation d'un film en utilisant la composition d'encre selon l'une quelconque des revendications 1 à 5.

7. Processus de préparation d'un dispositif de conversion photoélectrique organique présentant une première électrode et une deuxième électrode et présentant un film en tant que couche active entre ladite première électrode et ladite deuxième électrode, dans lequel le processus comprend la préparation du film en utilisant la composition d'encre selon l'une quelconque des revendications 1 à 5.

8. Processus de préparation d'un module de batterie solaire ou d'un capteur présentant un dispositif de conversion photoélectrique organique, le dispositif de conversion photoélectrique organique présentant une première électrode et une deuxième électrode et présentant un film en tant que couche active entre ladite première électrode et ladite deuxième électrode, dans lequel le processus comprend la préparation du film en utilisant la composition d'encre selon l'une quelconque des revendications 1 à 5.
